# EUROPEAN PATENT SPECIFICATION

(11) **EP 4 470 004 B1**
(45) Date of publication and mention of the grant of the patent: **31.12.2025**
(21) Application number: 23727204.2
(22) Date of filing: 29.04.2023
(51) Int. Cl.: G11C 11/56, G11C 16/04, G11C 16/08, G11C 16/20, G11C 16/22, G11C 16/10, G11C 16/26, G11C 16/34

(54) **MEMORY DEVICE AND OPERATION THEREOF**
SPEICHERVORRICHTUNG UND BETRIEB DAVON
DISPOSITIF DE MÉMOIRE ET SON FONCTIONNEMENT

(30) Priority: 30.12.2022 US 202263436437 P
(43) Date of publication of application: 04.12.2024
(73) Proprietor: Yangtze Memory Technologies Co., Ltd., Wuhan, Hubei 430000 (CN)
(72) Inventor: GUO, Xiaojiang, Wuhan, Hubei 430000 (CN)
(74) Representative: Gramm, Lins & Partner Patent- und Rechtsanwälte PartGmbB
(86) International application number: PCT/CN2023/091916
(87) International publication number: WO 2024/138986

(56) References cited:
- EP-A1- 3 422 351
- US-A1- 2022 199 165
- US-A1- 2022 319 617

## Description

### CROSS-REFERENCE TO RELATED APPLICATIONS

This application claims the benefit of priority to U.S. Provisional Application No. 63/436,437, filed on December 30, 2022.

### BACKGROUND

The present disclosure relates to memory devices and operation methods thereof.

Flash memory is a low-cost, high-density, non-volatile solid-state storage medium that can be electrically erased and re-programmed. Flash memory includes NOR Flash memory and NAND Flash memory. Various operations can be performed by Flash memory, such as read, program (write), and erase. For NAND Flash memory, an erase operation can be performed at the block level, and a program operation or a read operation can be performed at the page level.

Document US 2022/199165 A1 discloses a double interleaved programming of a memory device.

### SUMMARY

One aspect relates to a memory device according claim 1.

The peripheral circuit is configured to read the *M* data pages of the *N* data pages from the select row in response to a trigger event occurring.

In some implementations, the *k* intermediate levels correspond to *k* threshold voltage ranges, respectively, of the memory cells of the select row, and at least two threshold voltage ranges corresponding to two adjacent intermediate levels of the *k* intermediate levels are non-overlapping.

In some implementations, to read the *M* data pages, the peripheral circuit comprises a word line driver coupled to the select row through a select word line of the word lines, and configured to apply an adjusted read voltage between the two threshold voltage ranges to the select word line.

In some implementations, to program the select row, the word line driver is further configured to apply an adjusted verify voltage to the select word line for verifying a lower level of the two adjacent intermediate levels. In some implementations, the adjusted verify voltage is smaller than a default verify voltage for verifying the lower level of the two adjacent intermediate levels.

In some implementations, the peripheral circuit is further configured to, in response to a trigger event not occurring, skip reading the *M* data pages of the *N* data pages from the select row, and program, in a second pass, the select row of the rows of the memory cells based on the *N* data pages after the first pass, such that each memory cell of the selected row is set to one of the 2*^{N}* final levels.

In some implementations, the peripheral circuit is further configured to read the *N* data pages from the select row after the second pass.

In some implementations, to read the *N* data pages, the word line driver is configured to apply a default read voltage corresponding to the two adjacent intermediate levels based on a Gray code for programming the memory cells to the select word line, the adjusted read voltage being adjusted from the default read voltage by an offset.

The peripheral circuit is further configured to copy remaining *(N-M)* data pages to a designated block of the array of memory cells after the first pass.

In some implementations, the trigger event comprises power loss of the memory device.

Another aspect relates to a method for operating a memory device according to claim 9.

The method includes reading the *M* data pages of the *N* data pages from the select row is in response to a trigger event occurring.

In some implementations, the *k* intermediate levels correspond to *k* threshold voltage ranges, respectively, of the memory cells of the select row, and at least two threshold voltage ranges corresponding to two adjacent intermediate levels of the *k* intermediate levels are non-overlapping.

In some implementations, to reading the *M* data pages, an adjusted read voltage is applied between the two threshold voltage ranges to a select word line coupled to the select row.

In some implementations, to program the select row, an adjusted verify voltage is applied to the select word line for verifying a lower level of the two adjacent intermediate levels. In some implementations, the adjusted verify voltage is smaller than a default verify voltage for verifying the lower level of the two adjacent intermediate levels.

In some implementations, in response to a trigger event not occurring, reading the *M* data pages of the *N* data pages is skipped from the select row, and in a second pass, the select row of the rows of the memory cells is programmed based on the *N* data pages after the first pass, such that each memory cell of the selected row is set to one of the 2*^{N}* final levels.

In some implementations, the *N* data pages are read from the select row after the second pass.

In some implementations, to read the *N* data pages, a default read voltage corresponding to the two adjacent intermediate levels is applied based on a Gray code for programming the memory cells to the select word line. In some implementations, the adjusted read voltage is adjusted from the default read voltage by an offset.

The method includes copying remaining (*N-M*) data pages to a designated block of the memory device after the first pass.

In some implementations, the trigger event includes power loss of the memory device.

In some implementations, a system may include a memory device configured to store data and a memory controller coupled to the memory device and configured to control the memory device. The memory device includes an array of memory cells in columns and rows, word lines respectively coupled to rows of the memory cells, and a peripheral circuit coupled to the rows of memory cells through the word lines. Each memory cell is set to one of 2*^{N}* final levels corresponding to a piece of *N*-bits data, where *N* is an integer greater than 2. The peripheral circuit is configured to program, in a first pass, a select row of the rows of the memory cells based on *N* data pages, such that each memory cell of the selected row is set to one of *k* intermediate levels, where *k* is an integer not greater than *2^{N}.* The peripheral circuit is also configured to read *M* data pages of the *N* data pages from the select row after the first pass, where *M* is an integer smaller than *N*.

### BRIEF DESCRIPTION OF THE DRAWINGS

The accompanying drawings, which are incorporated herein and form a part of the specification, illustrate aspects of the present disclosure and, together with the description, further serve to explain the principles of the present disclosure and to enable a person skilled in the pertinent art to make and use the present disclosure.
FIG. 1 illustrates a schematic diagram of a memory device including peripheral circuits, according to some aspects of the present disclosure.
FIG. 2 illustrates a side view of a cross-section of a memory cell array including a NAND memory string, according to some aspects of the present disclosure.
FIG. 3 illustrates a block diagram of a memory device including a memory cell array and peripheral circuits, according to some aspects of the present disclosure.
FIG. 4 illustrates an example of threshold voltage distributions of memory cells in program operations, according to some aspects of the present disclosure.
FIG. 5 illustrates an example of threshold voltage distributions of memory cells in read operations, according to some aspects of the present disclosure.
FIG. 6 illustrates a block diagram of a page buffer in program operations, according to some aspects of the present disclosure.
FIGs. 7 and 8 illustrate an example of waveforms of word line voltages applied to a select word line in multi-pass program operations, according to some aspects of the present disclosure.
FIG. 9 illustrates an example of threshold voltage distributions of memory cells in a scheme of multi-pass program operations applied to quad-level cells (QLCs), according to some aspects of the present disclosure.
FIG. 10A illustrates an example of a Gray code for the scheme of multi-pass program operation in FIG. 9, according to some aspects of the present disclosure.
FIG. 10B illustrates an example of threshold voltage distributions of memory cells after the coarse program pass of the scheme of multi-pass program operation in FIG. 9, according to some aspects of the present disclosure.
FIG.11 illustrates an example of threshold voltage distributions of memory cells in another scheme of multi-pass program operations applied to QLCs, according to some aspects of the present disclosure.
FIG. 12A illustrates an example of a Gray code for the scheme of multi-pass program operation in FIG. 11, according to some aspects of the present disclosure.
FIG. 12B illustrates an example of threshold voltage distributions of memory cells after the coarse program pass of the scheme of multi-pass program operation in FIG. 11, according to some aspects of the present disclosure.
FIG.13 illustrates an example of threshold voltage distributions of memory cells in still another scheme of multi-pass program operations applied to QLCs, according to some aspects of the present disclosure.
FIG. 14A illustrates an example of a Gray code for the scheme of multi-pass program operation in FIG. 13, according to some aspects of the present disclosure.
FIG. 14B illustrates an example of threshold voltage distributions of memory cells after the coarse program pass of the scheme of multi-pass program operation in FIG. 13, according to some aspects of the present disclosure.
FIG. 15A illustrates another example of a Gray code for the scheme of multi-pass program operation in FIG. 13, according to some aspects of the present disclosure.
FIG. 15B illustrates another example of threshold voltage distributions of memory cells after the coarse program pass of the scheme of multi-pass program operation in FIG. 13, according to some aspects of the present disclosure.
FIG. 16 illustrates a flowchart of a method for operating a memory device, according to some aspects of the present disclosure.
FIG. 17 illustrates a block diagram of a system having a memory device, according to some aspects of the present disclosure.
FIG. 18A illustrates a diagram of a memory card having a memory device, according to some aspects of the present disclosure.
FIG. 18B illustrates a diagram of a solid-state drive (SSD) having a memory device, according to some aspects of the present disclosure.

The present disclosure will be described with reference to the accompanying drawings.

### DETAILED DESCRIPTION

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

Memory devices, such as NAND Flash memory devices, can store more than a single bit of information into each memory cell in multiple levels (a.k.a., states) in order to increase the storage capacity and reduce the cost per bit. In program operations, the data may be programmed (written) into xLCs, such as multi-level cells (MLCs), trip-level cells (TLCs), quad-level cells (QLCs), etc. For xLCs, for example, QLCs, multi-pass program operations can be used to reduce program time (tPROG) and increase read window margin (RWM), which involve a coarse program pass that programs the xLCs to one of the intermediate levels, as well as a fine program pass that programs the xLCs from the intermediate levels to the final levels. For example, for QLCs, there are different schemes of two-pass program operations: a 16-16 scheme in which the memory cells are first programmed to 16 levels in the coarse programming to maximize the read window margin, and then re-programmed to form 16 levels with smaller threshold voltage ranges in the fine programming; and a *K*-16 scheme in which the memory cells are first programmed to *K* levels in the coarse programming (*K*<16, e.g., 8 or 9) if the read window margin tradeoff is acceptable, and then programmed to 16 levels in the fine programming.

On the other hand, as part of power loss handling, the coarse data needs to be copied into a single-level cell (SLC) block. When a power loss occurs, the memory controller detects the power loss and sends a command to the NAND Flash memory device to write the coarse data to the SLC block. After power-on, the memory controller reads the coarse data stored at power loss from the SLC block and uses the coarse data to re-perform the coarse program pass of the multi-pass program operations. However, such a process involving the SLC blocks increases the duration of power loss handling, as well as the complexity of supporting the process.

Thus, it is desirable for NAND Flash memory devices to read back at least part of the coarse data between the coarse and fine passes during multi-pass program operations directly without involving the SLC block. However, since coarse data is written with a larger program step in incremental step pulse programming (ISPP) to reduce overall program time, it would be difficult to correctly read back coarse data due to not enough read window margin.

To address one or more of the aforementioned issues, the present disclosure introduces a coarse data read-back scheme that can read back a portion of the coarse-programmed data (e.g., one or more data pages of the data pages to be programmed by multi-pass program operations) in response to a trigger event occurring (e.g., recovery from power loss) using adjust read voltages that are adjusted from default read voltages by offsets. As a result, the total time for power loss handling can be reduced, and the system hardware and protocols for supporting the power loss handling can be simplified. In some implementations, to ensure sufficiently large read window margins between all adjacent intermediate levels after the coarse programming for read-back, verify voltage(s) used for certain intermediate level(s) are adjusted (e.g., reduced) during the coarse programming.

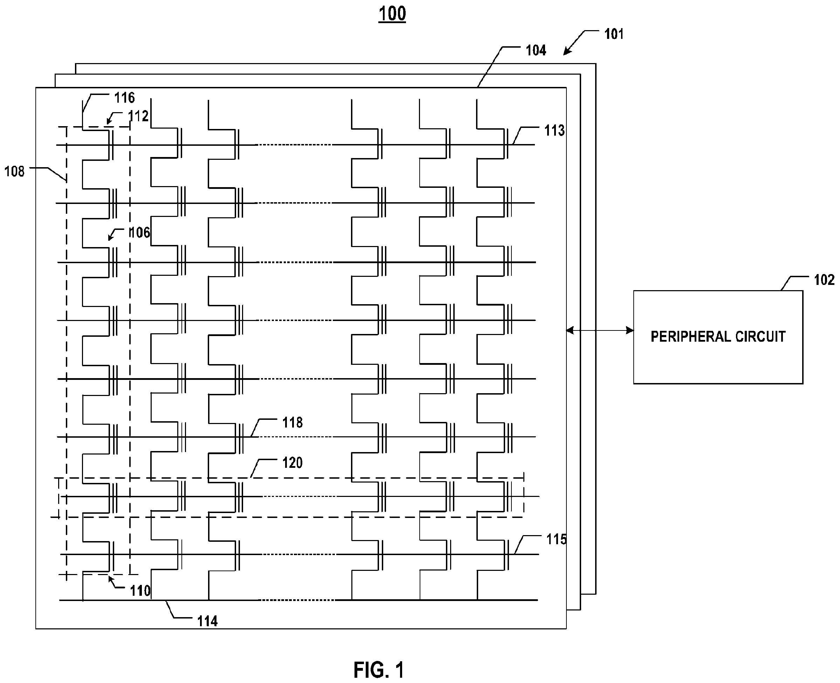

FIG. 1 illustrates a schematic circuit diagram of a memory device 100 including peripheral circuits, according to some aspects of the present disclosure. Memory device 100 can include a memory cell array 101 and peripheral circuits 102 coupled to memory cell array 101. Memory cell array 101 can be a NAND Flash memory cell array in which memory cells 106 are provided in the form of an array of NAND memory strings 108 each extending vertically above a substrate (not shown). In some implementations, each NAND memory string 108 includes a plurality of memory cells 106 coupled in series and stacked vertically. Each memory cell 106 can hold a continuous, analog value, such as an electrical voltage or charge, which depends on the number of electrons trapped within a region of memory cell 106. Each memory cell 106 can be either a floating gate type of memory cell including a floating-gate transistor or a charge trap type of memory cell including a charge-trap transistor.

In some implementations, each memory cell 106 is an SLC that has two possible levels (memory states) and thus, can store one bit of data. For example, the first state "0" can correspond to a first range of threshold voltages, and the second state "1" can correspond to a second range of threshold voltages. In some implementations, each memory cell 106 is an xLC that is capable of storing more than a single bit of data in more than four levels. For example, the xLC may store two bits per cell (MLC), three bits per cell (TLC), or four bits per cell (QLC)). Each xLC can be programmed to assume a range of possible nominal storage values (i.e., corresponding to 2*^{N}* pieces of *N*-bits data). In some implementations, each memory cell 106 is set to one of 2*^{N}* final levels corresponding to a piece of *N*-bits data, where *N* is an integer greater than 2.

As shown in FIG. 1, each NAND memory string 108 can also include a source select gate (SSG) transistor 110 at its source end and a drain select gate (DSG) transistor 112 at its drain end. SSG transistor 110 and DSG transistor 112 can be configured to activate select NAND memory strings 108 (columns of the array) during read and program operations. In some implementations, the sources of NAND memory strings 108 in the same block 104 are coupled through a same source line (SL) 114, e.g., a common SL. In other words, all NAND memory strings 108 in the same block 104 have an array common source (ACS), according to some implementations. The drain of each NAND memory string 108 is coupled to a respective bit line 116 from which data can be read or written via an output bus (not shown), according to some implementations. In some implementations, each NAND memory string 108 is configured to be selected or deselected by applying a select voltage or a deselect voltage to the gate of respective DSG transistor 112 through one or more DSG lines 113 and/or by applying a select voltage or a deselect voltage to the gate of respective SSG transistor 110 through one or more SSG lines 115.

As shown in FIG. 1, NAND memory strings 108 can be organized into multiple blocks 104, each of which can have a common source line 114, e.g., coupled to the ACS. In some implementations, each block 104 is the basic data unit for erase operations, i.e., all memory cells 106 on the same block 104 are erased at the same time. To erase memory cells 106 in a select block 104, source lines 114 coupled to select block 104 as well as unselect blocks 104 in the same plane as select block 104 can be biased with an erase voltage (Vers), such as a high positive bias voltage (e.g., 20 V or more). Consistent with the scope of the present disclosure, at least one of blocks 104 is an SLC block configured to temporarily store one or more coarse-programmed data pages (i.e., part of the coarse data) that are copied into the SLC block in response to power loss during multi-pass program operations, according to some implementations.

Memory cells 106 of adjacent NAND memory strings 108 can be coupled through word lines 118 that select which row of memory cells 106 is affected by read and program operations. In some implementations, each word line 118 is coupled to a physical page 120 of memory cells 106, which is the basic data unit for read and program operations. The size of one physical page 120 in bits can relate to the number of NAND memory strings 108 coupled by word line 118 in one block 104. Each word line 118 can include a plurality of control gates (gate electrodes) at each memory cell 106 in respective physical page 120 and a gate line coupling the control gates.

As shown in FIG. 1, memory cell array 101 can include an array of memory cells 106 in a plurality of rows and a plurality of columns in each block 104. One row of memory cells 106 corresponds to one or more physical pages 120, and one column of memory cells corresponds to one NAND memory string 108, according to some implementations. The plurality of rows of memory cells 106 can be respectively coupled to word lines 118, and the plurality of columns of memory cells 106 can be respectively coupled to bit lines 116. Peripheral circuit 102 can be coupled to memory cell array 101 through bit lines 116 and word lines 118.

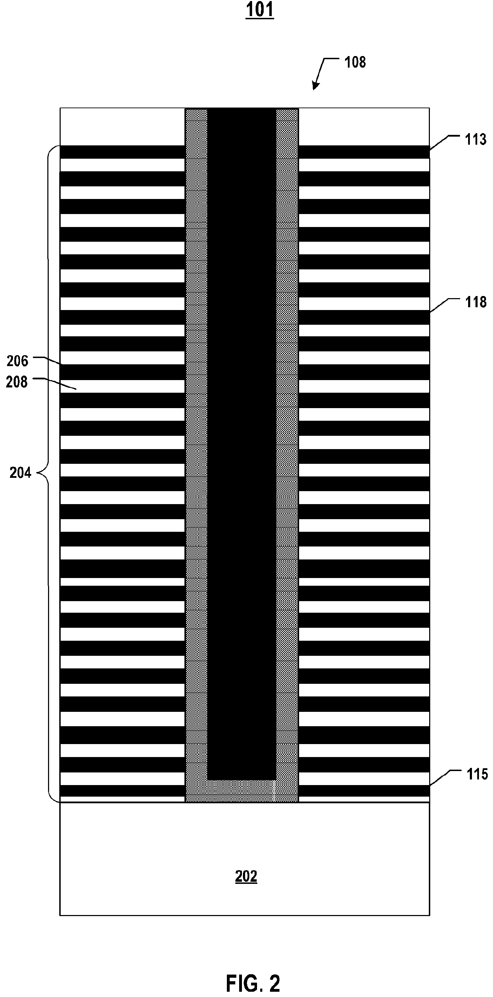

FIG. 2 illustrates a side view of a cross-section of memory cell array 101 including NAND memory string 108, according to some aspects of the present disclosure. As shown in FIG. 2, NAND memory string 108 can extend vertically through a memory stack 204 above a substrate 202. Substrate 202 can include silicon (e.g., single crystalline silicon), silicon germanium (SiGe), gallium arsenide (GaAs), germanium (Ge), silicon on insulator (SOI), germanium on insulator (GOI), or any other suitable materials.

Memory stack 204 can include interleaved gate conductive layers 206 and gate-to-gate dielectric layers 208. The number of the pairs of gate conductive layers 206 and gate-to-gate dielectric layers 208 in memory stack 204 can determine the number of memory cells 106 in memory cell array 101. Gate conductive layer 206 can include conductive materials including, but not limited to, tungsten (W), cobalt (Co), copper (Cu), aluminum (Al), polysilicon, doped silicon, silicides, or any combination thereof. In some implementations, each gate conductive layer 206 includes a metal layer, such as a tungsten layer. In some implementations, each gate conductive layer 206 includes a doped polysilicon layer. Each gate conductive layer 206 can include control gates surrounding memory cells 106, the gates of DSG transistors 112, or the gates of SSG transistors 110, and can extend laterally as DSG line 113 at the top of memory stack 204, SSG line 115 at the bottom of memory stack 204, or word line 118 between DSG line 113 and SSG line 115.

As shown in FIG. 2, NAND memory string 108 includes a channel structure extending vertically through memory stack 204. In some implementations, the channel structure includes a channel hole filled with semiconductor material(s) (e.g., as a semiconductor channel) and dielectric material(s) (e.g., as a memory film). It is understood that although not shown in FIG. 2, additional components of memory cell array 101 can be formed including, but not limited to, gate line slits/source contacts, local contacts, interconnect layers, etc.

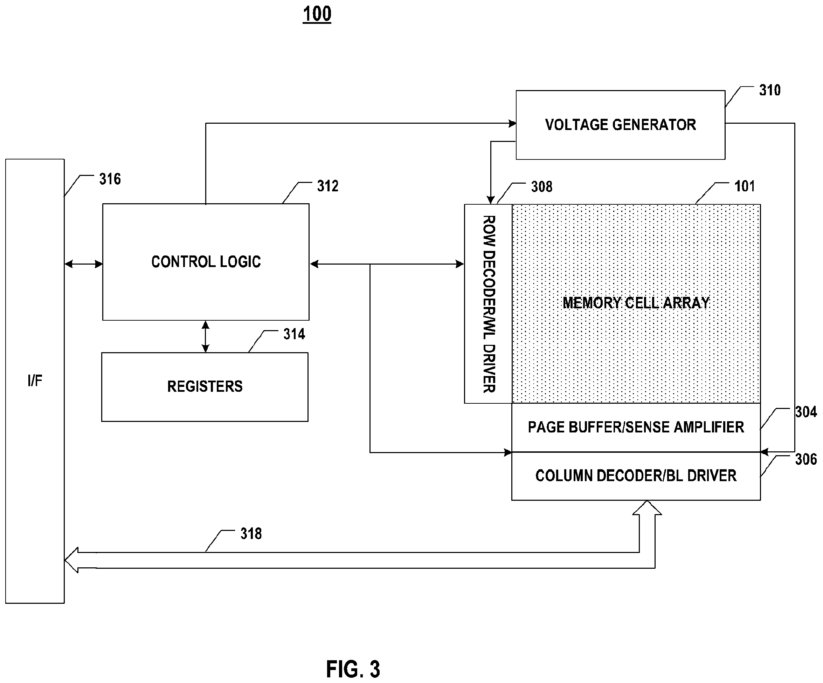

Referring back to FIG. 1, peripheral circuits 102 can be coupled to memory cell array 101 through bit lines 116, word lines 118, source lines 114, SSG lines 115, and DSG lines 113. Peripheral circuits 102 can include any suitable analog, digital, and mixed-signal circuits for facilitating the operations of memory cell array 101 by applying and sensing voltage signals and/or current signals to and from each select memory cell 106 through bit lines 116, word lines 118, source lines 114, SSG lines 115, and DSG lines 113. Peripheral circuits 102 can include various types of peripheral circuits formed using metal-oxide-semiconductor (MOS) technologies. For example, FIG. 3 illustrates some exemplary peripheral circuits including a page buffer/sense amplifier 304, a column decoder/bit line driver 306, a row decoder/word line driver 308, a voltage generator 310, control logic 312, registers 314, an interface (I/F) 316, and a data bus 318. It is understood that in some examples, additional peripheral circuits not shown in FIG. 3 may be included as well.

Page buffer/sense amplifier 304 can be configured to sense (read) and program (write) data from and to memory cell array 101 according to the control signals from control logic 312. In one example, page buffer/sense amplifier 304 may store one page of program data (write data, referred to herein as "data page") to be programmed into one physical page 120 of memory cell array 101. In another example, page buffer/sense amplifier 304 may verify programmed select memory cells 106 in each program/verify cycle in a program operation to ensure that the data has been properly programmed into memory cells 106 coupled to select word lines 118. In still another example, page buffer/sense amplifier 304 may also sense the low power signals from bit line 116 that represents a data bit stored in memory cell 106 and amplify the small voltage swing to recognizable logic levels in a read operation. Consistent with the scope of the present disclosure, page buffer/sense amplifier 304 is configured to temporarily store one or more coarse-programmed data pages (i.e., part of the coarse data) that are read back from memory cells 106 in response to the recovery of power loss during multi-pass program operations, according to some implementations.

Column decoder/bit line driver 306 can be configured to be controlled by control logic 312 and select one or more NAND memory strings 108 by applying bit line voltages generated from voltage generator 310. Row decoder/word line driver 308 can be configured to be controlled by control logic 312 and select/deselect blocks 104 of memory cell array 101 and select/deselect word lines 118 of block 104. Row decoder/word line driver 308 can be further configured to drive word lines 118 using word line voltages generated from voltage generator 310. In some implementations, row decoder/word line driver 308 can also select/deselect and drive SSG lines 115 and DSG lines 113 as well. Voltage generator 310 can be configured to be controlled by control logic 312 and generate the word line voltages (e.g., read voltage, program voltage, channel pass voltage, local voltage, verify voltage, etc.), bit line voltages, and source line voltages to be supplied to memory cell array 101.

Control logic 312 can be coupled to each peripheral circuit described above and configured to control the operations of each peripheral circuit. Registers 314 can be coupled to control logic 312 and include status registers, command registers, and address registers for storing status information, command operation codes (OP codes), and command addresses for controlling the operations of each peripheral circuit. Interface 316 can be coupled to control logic 312 and act as a control buffer to buffer and relay control commands received from a memory controller (not shown) and/or a host (not shown) to control logic 312 and status information received from control logic 312 to the memory controller and/or the host. Interface 316 can also be coupled to column decoder/bit line driver 306 via data bus 318 and act as a data input/output (I/O) interface and a data buffer to buffer and relay the data to and from memory cell array 101.

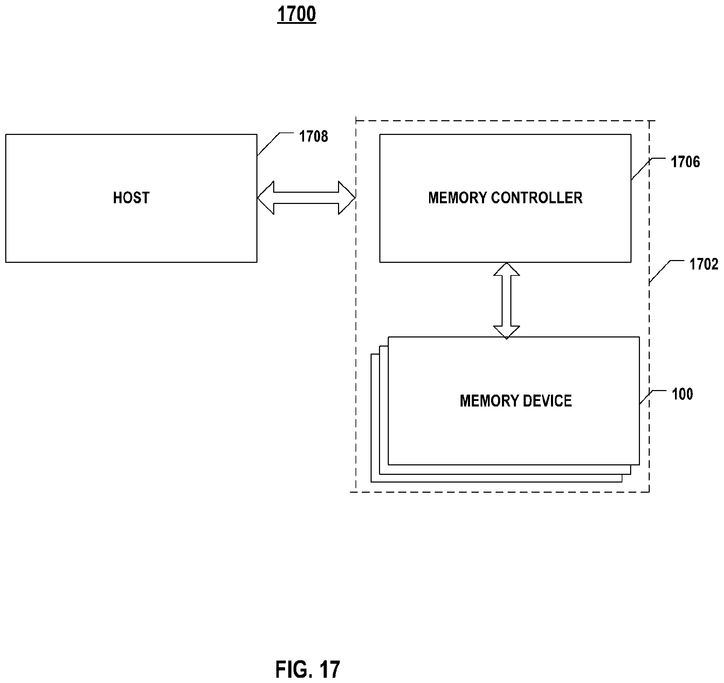

FIG. 17 illustrates a block diagram of a system 1700 having a memory device, according to some aspects of the present disclosure. System 1700 can be a mobile phone, a desktop computer, a laptop computer, a tablet, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 17, system 1700 can include a host 1708 and a memory system 1702 having one or more memory devices 100 (shown in FIG. 1) and a memory controller 1706. Host 1708 can be a processor of an electronic device, such as a central processing unit (CPU), or a system-on-chip (SoC), such as an application processor (AP). Host 1708 can be configured to send or receive data to or from memory devices 100.

Memory device 100 can be any memory device disclosed in the present disclosure. Memory controller 1706 is coupled to memory device 100 and host 1708 and is configured to control memory device 100, according to some implementations. Memory controller 1706 can manage the data stored in memory device 100 and communicate with host 1708. In some implementations, memory controller 1706 is designed for operating in a low duty-cycle environment like secure digital (SD) cards, compact Flash (CF) cards, universal serial bus (USB) Flash drives, or other media for use in electronic devices, such as personal computers, digital cameras, mobile phones, etc. In some implementations, memory controller 1706 is designed for operating in a high duty-cycle environment SSDs or embedded multi-media-cards (eMMCs) used as data storage for mobile devices, such as smartphones, tablets, laptop computers, etc., and enterprise storage arrays. Memory controller 1706 can be configured to control operations of memory device 100, such as read, erase, and program operations. Memory controller 1706 can also be configured to manage various functions with respect to the data stored or to be stored in memory device 100 including, but not limited to bad-block management, garbage collection, logical-to-physical address conversion, wear leveling, etc. In some implementations, memory controller 1706 is further configured to process error correction codes (ECCs) with respect to the data read from or written to memory device 100. Any other suitable functions may be performed by memory controller 1706 as well, for example, formatting memory device 100. Memory controller 1706 can communicate with an external device (e.g., host 1708) according to a particular communication protocol. For example, memory controller 1706 may communicate with the external device through at least one of various interface protocols, such as a USB protocol, a multimedia card (MMC) protocol, a peripheral component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc.

In some implementations, in response to a trigger event occurring (e.g., power loss) during a multi-pass program operation, memory controller 1706 is configured to control memory device 100 to write part of the coarse data (e.g., one or more coarse-programed data pages) to an SLC block of memory device 100; in response to another trigger event occurring (e.g., recovery of the power loss), memory controller 1706 is configured to control memory device 100 to read the part of the coarse data from the SLC block. Consistent with the scope of the present disclosure, in response to the other trigger event occurring (e.g., recovery of the power loss), memory controller 1706 is further configured to control memory device 100 to read back the rest of the coarse data (e.g., the rest of the coarse-programed data page(s)) from memory cells 106 of memory device 100 using adjusted read voltages and temporary store the read-back coarse data in page buffer 304 of memory device 100 and/or in a volatile memory device (not shown, e.g., a dynamic random-access memory (DRAM) device) in memory system 1702. In some implementations, memory controller 1706 is further configured to control memory device 100 to re-perform the coarse programming of the multi-pass program operation based on the retrieved coarse data (e.g., all coarse-programed data pages).

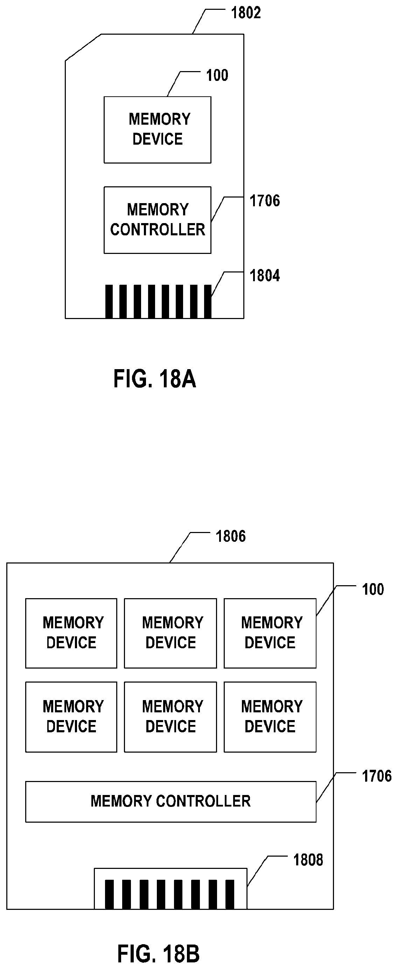

Memory controller 1706 and one or more memory devices 100 can be integrated into various types of storage devices, for example, being included in the same package, such as a universal Flash storage (UFS) package or an eMMC package. That is, memory system 1702 can be implemented and packaged into different types of end electronic products. In one example as shown in FIG. 18A, memory controller 1706 and a single memory device 100 may be integrated into a memory card 1802. Memory card 1802 can include a PC card (PCMCIA, personal computer memory card international association), a CF card, a smart media (SM) card, a memory stick, a multimedia card (MMC, RS-MMC, MMCmicro), an SD card (SD, miniSD, microSD, SDHC), a UFS, etc. Memory card 1802 can further include a memory card connector 1804 coupling memory card 1802 with a host (e.g., host 1708 in FIG. 17). In another example as shown in FIG. 18B, memory controller 1706 and multiple memory devices 100 may be integrated into an SSD 1806. SSD 1806 can further include an SSD connector 1808 coupling SSD 1806 with a host (e.g., host 1708 in FIG. 17). In some implementations, the storage capacity and/or the operation speed of SSD 1806 is greater than those of memory card 1802.

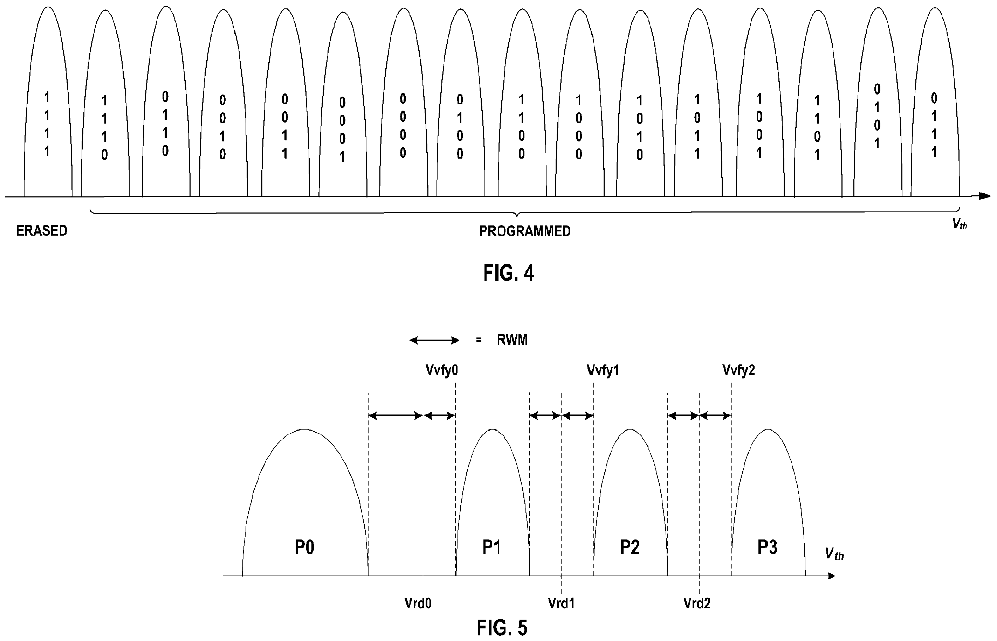

FIG. 4 illustrates an example of threshold voltage distributions of memory cells in program operations, according to some aspects of the present disclosure. As described above, each memory cell 106 can be configured to be set to one of 2*^{N}* final levels corresponding to a piece of N-bits data, where Nis an integer greater than 2 (e.g., *N*= 3 for TLCs, *N*= 4 for QLCs, etc.). Each level can correspond to one of *2^{N}* threshold voltage (*Vth*) ranges of memory cells 106. Considering a multi-pass program operation in which memory cell 106 may be programmed into an intermediate level first in a coarse program pass (a.k.a., coarse programming), the "level" referred to herein may be considered as the final level after the fine program pass (a.k.a., fine programming) of the multi-pass program operations, in contrast to the intermediate level. Taking QLCs, where *N* = 4, for example, as shown in FIG. 4, memory cell 106 may be set into one of the 16 levels, including one level of the erased state and 15 levels of the programmed states. Each level may correspond to a respective threshold voltage (*Vth*) range of memory cells 106. For example, the level corresponding to the lowest threshold voltage range (the left-most threshold voltage range in FIG. 4) may be considered as level 0 (P0), the level corresponding to the second-lowest threshold voltage range (the second left-most threshold voltage range in FIG. 4) may be considered as level 1 (P1), and so until level 15 (P15) corresponding to the highest threshold voltage range (the rightmost threshold voltage range in FIG. 4).

On the other hand, each level can correspond to one of the 2*^{N}* pieces of *N*-bits data. In some implementations, the 2*^{N}* pieces of *N*-bits data may be represented by (in the form of) a Gray code. A Gray code (a.k.a., reflected binary code (RBC) or reflected binary (RB)) is an ordering of the binary numeral system such that two successive values differ in only one bit (binary digit). For example, TABLE 1 below shows an example of a binary code representing a one-to-one mapping between 16 levels (P0 to P15) and 16 pieces of 4-bits data used in the example of FIG. 4. As shown in TABLE 1, each piece of 4-bits data may consist of four bits of binary values (b1, b2, b3, and b4). In one example, level 1 may correspond to a piece of 4-bits data having a value of 1111. In another example, level 15 may correspond to another piece of 4-bits data having a value of 1110.

**TABLE 1**

| **Lvl** | **P0** | **P1** | **P2** | **P3** | **P4** | **P5** | **P6** | **P7** | **P8** | **P9** | **P10** | **P11** | **P12** | **P13** | **P14** | **P15** |
|---|---|---|---|---|---|---|---|---|---|---|---|---|---|---|---|---|
| **b1** | 1 | 1 | 0 | 0 | 0 | 0 | 0 | 0 | 1 | 1 | 1 | 1 | 1 | 1 | 0 | 0 |
| **b2** | 1 | 1 | 1 | 0 | 0 | 0 | 0 | 1 | 1 | 0 | 0 | 0 | 0 | 1 | 1 | 1 |
| **b3** | 1 | 1 | 1 | 1 | 1 | 0 | 0 | 0 | 0 | 0 | 1 | 1 | 0 | 0 | 0 | 1 |
| **b4** | 1 | 0 | 0 | 0 | 1 | 1 | 0 | 0 | 0 | 0 | 0 | 1 | 1 | 1 | 1 | 1 |

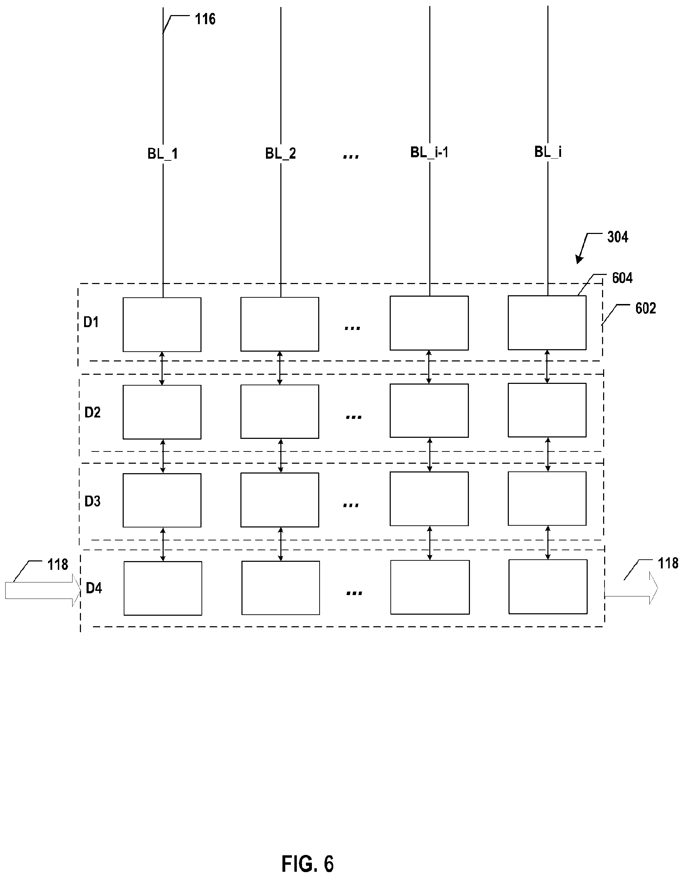

Also referring to FIG. 3, in a program operation, *N* data pages of the *N*-bits data transmitted through data bus 318 can be temporarily stored in page buffer/sense amplifier 304, and page buffer/sense amplifier 304 can be configured to provide to each target memory cell 316 the corresponding piece of *N*-bits data through the corresponding bit line 116. For example, FIG. 6 illustrates a block diagram of exemplary page buffer/sense amplifier 304 in program operations, according to some aspects of the present disclosure. In some implementations, page buffer/sense amplifier 304 includes *N* storage modules 602 (e.g., latches and/or caches) each configured to temporarily store one of *N* data pages. That is, the *N*-bits data (having 2*^{N}* values) to be stored by a row of target memory cells 106 coupled to a selected word line 118 can be transmitted, stored, and provided in the form of *N* data pages of *N*-bits data in a program operation.

Still taking QLCs, where N = 4, for example, as shown in FIG. 6, page buffer/sense amplifier 304 may include 4 storage modules 602 (D1, D2, D3, and D4) each configured to temporarily store one of 4 data pages. Each storage module 602 may include i storage units 604 (e.g., registers) corresponding to i target memory cells 106 in a row of memory cells 106 coupled to a selected word line 118 in a program operation. That is, each target memory cell 106 may be coupled to a corresponding set of four storage units 604 from each of four storage modules 602 (D1, D2, D3, and D4) through a respective bit line 116 (BL_1, BL_2, ..., BL_i-1, or BL_i). For each target memory cell 106 in a program operation, the four bits of binary values in the corresponding piece of 4-bits data (e.g., b1, b2, b3, and b4 according to the gray code in TABLE 1) may be temporarily stored in the corresponding set of four storage units 604, respectively, such that the corresponding piece of 4-bits data may be provided to target memory cell 106 by page buffer/sense amplifier 304.

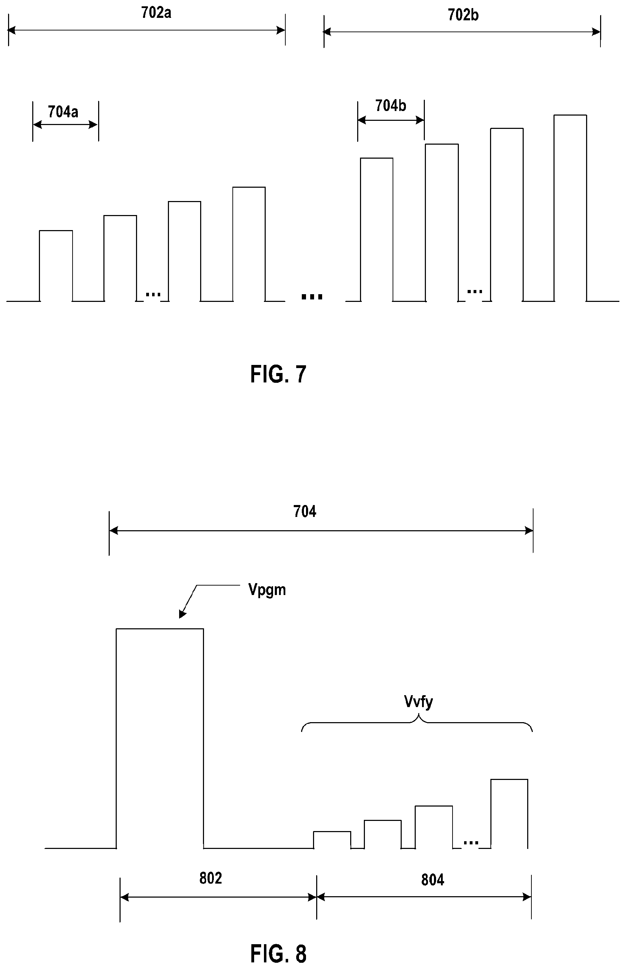

To perform a program operation, in addition to page buffer/sense amplifier 304 providing to each target memory cell 106 the corresponding piece of *N*-bits data, row decoder/word line driver 308 can be configured to apply program voltages and verify voltages to a selected word line 118 coupled to a row of target memory cells 106 in one or more program/verify loops in order to raise the threshold voltage of each target memory cell 106 to a desired level (into a desired range of threshold voltages) based on the corresponding piece of *N*-bits data. For example, FIGs. 7 and 8 illustrate an example of waveforms of word line voltages applied to a select word line in multi-pass program operations, according to some aspects of the present disclosure. As shown in FIG. 7, the multi-pass program operation includes at least a first pass 702a (a.k.a., a coarse program pass, e.g., a non-last program pass) and a second pass 702b (a.k.a., a fine program pass, e.g., the last program pass) after first pass 702a. First pass 702a includes one or more program/verify cycles 704a, and second pass 702b includes one or more program/verify cycles 704b as well.

As shown in FIG. 8, in each program/verify cycle 704, regardless of whether it is in first pass 702a or second pass 702b, a program voltage (Vpgm) is applied to the selected word line, followed by a number of verify voltages (Vvfy) with incremental changes of voltage levels. As shown in FIG. 8, in each program/verify cycle 704, row decoder/word line driver 308 can be configured to apply a program voltage (Vpgm) on select word line 118 to select row of memory cells 106 in a program cycle 802 and sequentially apply one or more verify voltages (Vvfy) with incremental changes of voltage levels to verify select row of memory cells 106 in a verify cycle 804. That is, peripheral circuit 102 can perform verification of select row of memory cells 106 at one or more levels in verify cycle 804 after applying a program voltage in program cycle 802. The number of verify voltages applied in verify cycle 804 depends on the level being programmed by the specific program/verify cycle 704, according to some implementations. As a result, at the end of the program operation, select memory cell 106 can be programmed into one of the 2*^{N}* levels based on the corresponding *N* bits of data to be stored in select memory cell 106.

Consistent with the scope of the present disclosure, multi-pass program operations can be implemented using any suitable *k*-2*^{N}* schemes (where *k* is an integer not greater than 2*^{N}*) in which the number of intermediate levels *k* is the same as the number of final levels 2*^{N}* (e.g., 16-16 schemes for QLCs), or the number of intermediate levels *k* is smaller than the number of final levels 2*^{N}* (e.g., 8-16 schemes or 9-16 schemes for QLCs). In a multi-pass program operation, in the fine program pass (e.g., the last program pass that programs each target memory cell 106 into a final level), each target memory cell 106 can be set into one of the 2*^{N}* final levels. As to the coarse program pass (e.g., any non-last program pass that programs each target memory cell 106 into an intermediate level), each target memory cell 106 is set into one of the *k* intermediate levels (where *k* ≤ 2*^{N}*).

As shown in FIG. 8, the number of verify voltages applied in each verify cycle 804 can determine the number of intermediate levels or the number of final levels into which target memory cell 106 can be set in the coarse program pass or the fine program pass. In some implementations, in the coarse program pass, (*k*-1) verify voltages is applied in verify cycle 804 by word line driver 308 to select word line 118 to form *k* intermediate levels, while in the fine program pass, (2*^{N}*-1) verify voltages is applied in verify cycle 804 by word line driver 308 to select word line 118 to form 2*^{N}* final levels.

As shown in FIG. 5, verify voltages Vvfy0, Vvfy1, and Vvfy 2 can define the threshold voltage ranges of the corresponding levels P1, P2, and P3, respectively, by setting the lower bounds of the threshold voltage ranges. The widths of the threshold voltage ranges can be set, for example, by the corresponding program voltage Vpgm (shown in FIG. 8). The read window margins (RWM) between adjacent levels (threshold voltage ranges), as well as the read voltages Vrd, thus can be defined by the verify voltages Vvfy and program voltage Vpgm. For example, by adjusting the verify voltages Vvfy0, Vvfy1, and Vvfy 2 during program operations, the read window margins between levels P0, P1, P2, and P3, as well as the corresponding read voltages Vrd0, Vrd1, and Vrd 2 between levels P0, P1, P2, and P3 may be adjusted, respectively.

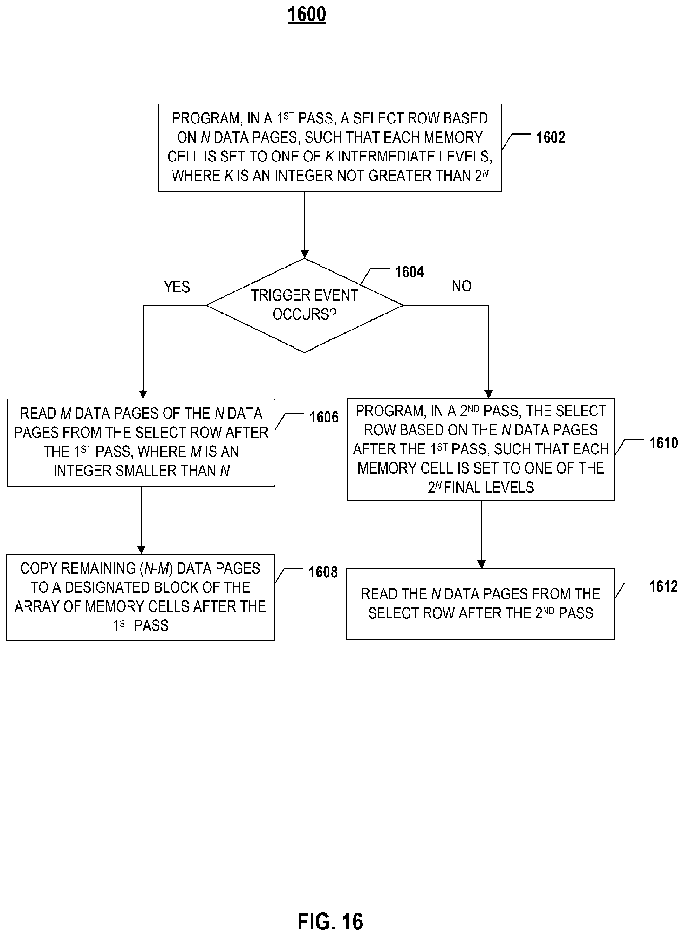

FIG. 16 illustrates a flowchart of a method 1600 for operating a memory device, according to some aspects of the present disclosure. The memory device may be any suitable memory device disclosed herein, such as memory device 100. Method 1600 may be implemented by peripheral circuit 102, such as row decoder/word line driver 308, page buffer/sense amplifier 304, and control logic 312. It is understood that the operations shown in method 1600 may not be exhaustive and that other operations can be performed as well before, after, or between any of the illustrated operations. Further, some of the operations may be performed simultaneously, or in a different order than shown in FIG. 16.

Referring to FIG. 16, method 1600 starts at operation 1602, in which a select row of memory cells are programmed, in a first pass, based on *N* data pages, such that each memory cell of the selected row is set to one of *k* intermediate levels, where *k* is an integer not greater than 2*^{N}.* In some implementations, to program the select row, an adjusted verify voltage is applied to the select word line for verifying a lower level of the two adjacent intermediate levels. The adjusted verify voltage can be smaller than a default verify voltage for verifying the lower level of the two adjacent intermediate levels.

For example, in a multi-pass program operation, peripheral circuit 102 can be configured to program, in first pass 702a (e.g., a coarse program pass), a select row of memory cells 106 based on *N* data pages, such that each memory cell 106 of the selected row is set to one of *k* intermediate levels. Each memory cell 106 is set to one of 2*^{N}* final levels corresponding to a piece of *N*-bits data, where *N* is an integer greater than 2, and *k* is an integer not greater than 2*^{N}.* The *k* intermediate levels can correspond to *k* threshold voltage ranges, respectively, of the select row of memory cells 106. In some implementations, to program the select row of memory cells 106 in first pass 702a, word line driver 308 is configured to apply, in program cycle 802, a first program voltage Vpgm (e.g., a coarse program voltage) to a select word line 118 to which the select row of memory cells 106 are coupled, and then apply, in verify cycle 804, a set of first verify voltages Vvfy (e.g., coarse verify voltages) to select word line 118 for verifying and thus, forming the intermediate levels. For example, the set of coarse verify voltages may include (*k*-1) verify voltages for verifying and forming *k* intermediate levels in first pass 702a.

Method 1600 proceeds to operation 1604, as illustrated in FIG. 16, in which whether a trigger event occurs is determined. The trigger event can include power loss of the memory device. If the answer to operation 1604 is "NO," method 1600 proceeds to operation 1610, as illustrated in FIG. 16, in which the select row of memory cells are programmed, in a second pass, based on the *N* data pages after the first pass, such that each memory cell of the selected row is set to one of the 2*^{N}* final levels. That is, operation 1606 in which *M* data pages of the *N* data pages are read from the select row after the first pass may be skipped if the trigger event does not occur.

For example, if the muti-pass program operation proceeds normally, e.g., without any interruption, peripheral circuit 102 can be configured to program, in second pass 702b (e.g., a fine program pass), select row of memory cells 106 based on the N data pages after first pass 702a, such that each memory cell of the selected row is set to one of the 2*^{N}* final levels. The 2*^{N}* final levels can correspond to 2*^{N}* threshold voltage ranges, respectively, of the select row of memory cells 106. In some implementations, to program the select row of memory cells 106 in second pass 702b, word line driver 308 is configured to apply, in program cycle 802, a second program voltage Vpgm (e.g., a fine program voltage) to select word line 118, and then apply, in verify cycle 804, a set of second verify voltages Vvfy (e.g., fine verify voltages) to select word line 118 for verifying and thus, forming the final levels. For example, the set of fine verify voltages may include (2*^{N}*-1) verify voltages for verifying and forming 2*^{N}* final levels in second pass 702b.

Method 1600 proceeds to operation 1612, as illustrated in FIG. 16, in which the *N* data pages are read from the select row after the second pass. For example, after the muti-pass program operation, each memory cell 106 of the select row of memory cells 106 can be set into one of the 2*^{N}* final levels based on the *N* data pages. Later in a read operation, peripheral circuit 102 can be configured to read the *N* data pages from the select row of memory cells 106 after second pass 702b of the muti-pass program operation. In some implementations, to read the *N* data pages, word line driver 308 is configured to apply a set of first read voltages Vrd (e.g., default read voltages) to select word line 118. For example, each default read voltage may correspond to two adjacent intermediate levels based on a Gray code for programming memory cells 106.

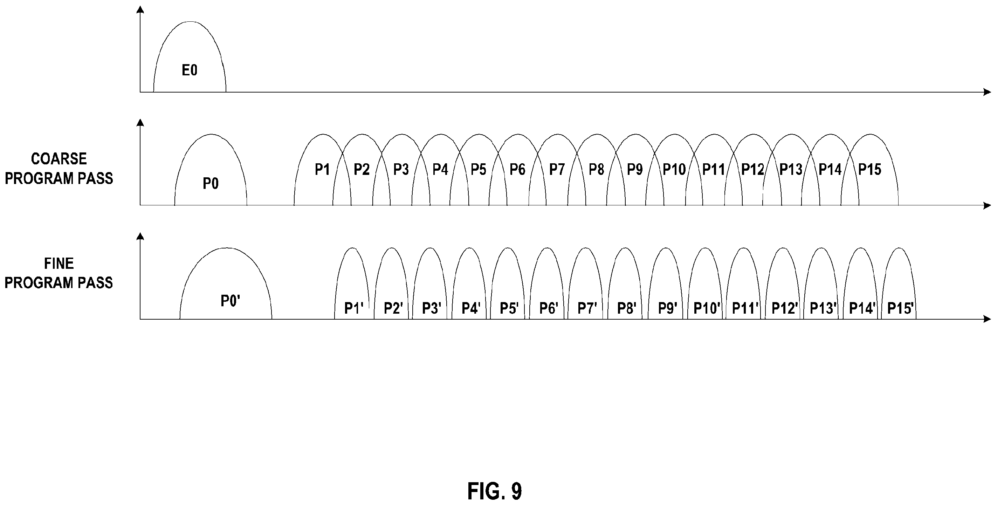

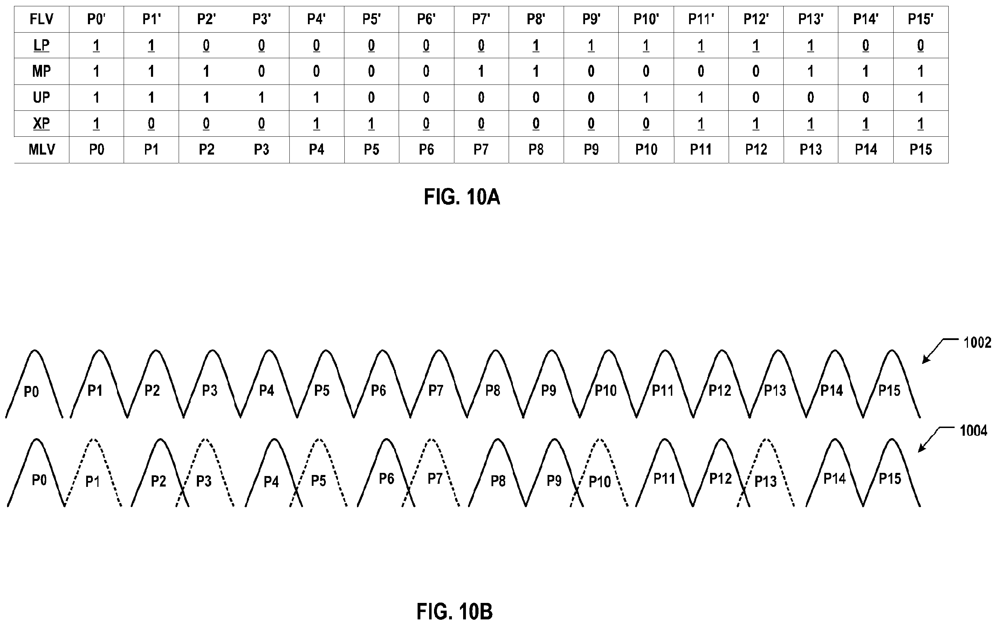

For example, FIG. 9 illustrates an example of threshold voltage distributions of memory cells in a first scheme of multi-pass program operations applied to QLCs, according to some aspects of the present disclosure. In this scheme, the number of intermediate levels *k* is equal to the number of final levels 2^{N}, e.g., 16 for QLCs. As shown in FIG. 9, after the coarse program pass, each memory cell 106 is set to one of 16 intermediate levels P0-P15; after the fine program pass, each memory cell 106 is further set to one of 16 final levels P0'-P15'. FIG. 10A illustrates an example of a Gray code for the scheme of multi-pass program operation in FIG. 10A, according to some aspects of the present disclosure. As shown in FIG. 9, four data pages (*N* = 4 for QLCs) includes a lower page LP, a middle page MP, an upper page UP, and an extra page XP, which are used for programming memory cells 106 into a corresponding one of 16 intermediate levels MLVs in the coarse program pass and a corresponding one of 16 final levels FLVs in the fine program pass according to the Gray code. As shown in FIG. 10A, each final level may correspond to one intermediate level.

In read operations, to read a data page of the four data pages, a set of default read voltages are applied to distinguish each two adjacent final levels that switch between "0" and "1" or vice versa in the corresponding row of the data page. As shown in FIG. 10A, in one example, for LP, a first default read voltage may be applied between P1 and P2, a second default read voltage may be applied between P7 and P8, and a third default read voltage may be applied between P13 and P14. In another example, for XP, a first default read voltage may be applied between P0 and P1, a second default read voltage may be applied between P3 and P4, a third default read voltage may be applied between P5 and P6, and a fourth default read voltage may be applied between P10 and P11.

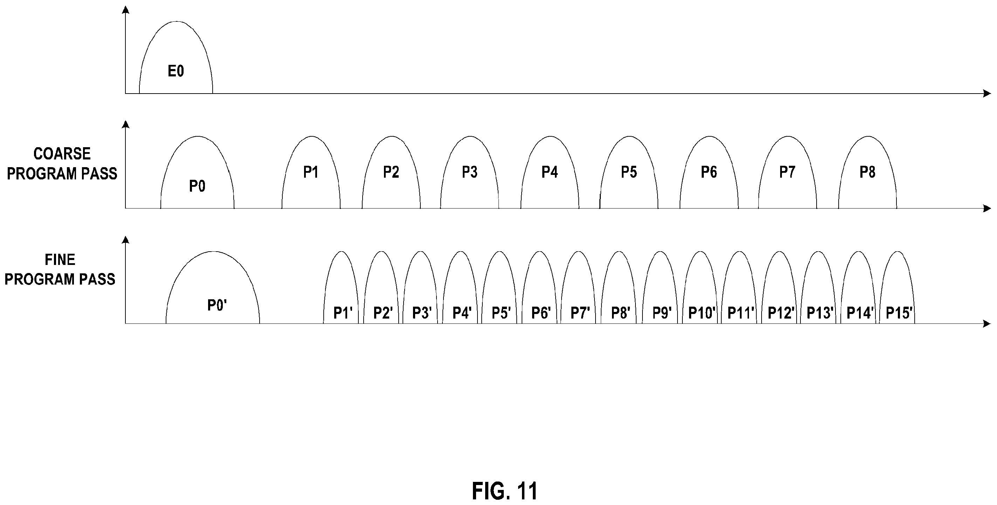

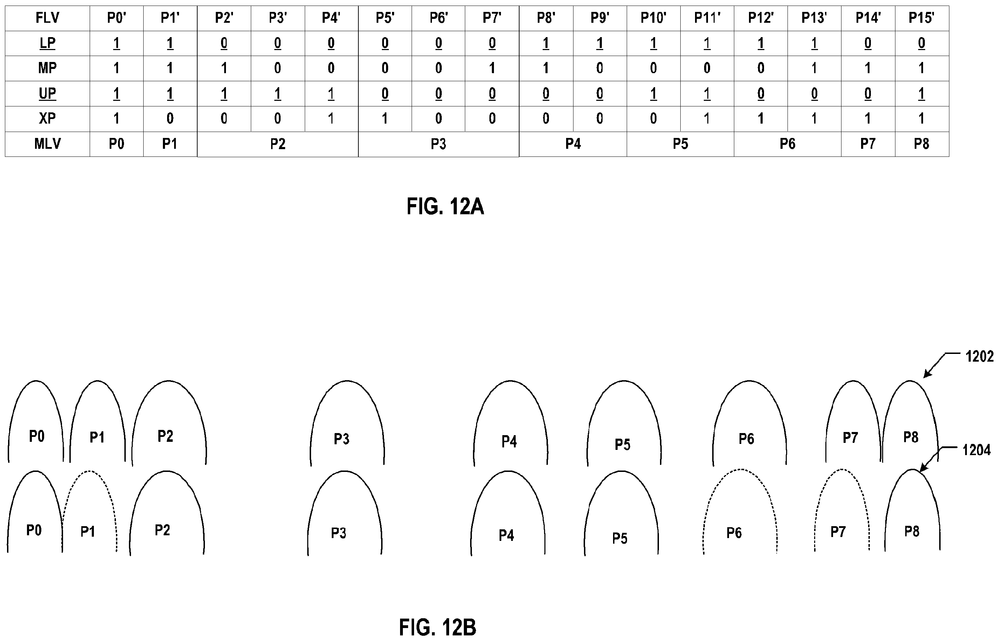

For example, FIG. 11 illustrates an example of threshold voltage distributions of memory cells in a second scheme of multi-pass program operations applied to QLCs, according to some aspects of the present disclosure. In this scheme, the number of intermediate levels *k,* e.g., 9, is smaller than the number of final levels 2^{N}, e.g., 16 for QLCs. As shown in FIG. 11, after the coarse program pass, each memory cell 106 is set to one of 9 intermediate levels P0-P8; after the fine program pass, each memory cell 106 is further set to one of 16 final levels PO'-P15'. FIG. 12A illustrates an example of a Gray code for the scheme of multi-pass program operation in FIG. 11, according to some aspects of the present disclosure. As shown in FIG. 12A, four data pages (*N =* 4 for QLCs) includes a lower page LP, a middle page MP, an upper page UP, and an extra page XP, which are used for programming memory cells 106 into a corresponding one of 9 intermediate levels MLVs in the coarse program pass and a corresponding one of 16 final levels FLVs in the fine program pass according to the Gray code. In some implementations, "0" in the Gray codes indicates an inhibited status, and "1" in the Gray codes indicates a programming status. As shown in FIG. 12A, each final level may correspond to one, two, or three intermediate levels. For example, intermediate levels P0, P1, P7, and P8 correspond to final level P0', P1', P14', and P15', respectively; intermediate level P4 corresponds to final levels P8' and P9'; intermediate level P5 corresponds to final levels P10' and P11'; intermediate level P6 corresponds to final levels P12' and P13'; intermediate level P2 corresponds to final levels P2', P3', and P4'; intermediate level P3 corresponds to final levels P5', P6', and P7'. It is understood that the mapping between intermediate levels and final levels may vary in different examples.

In read operations, to read a data page of the four data pages, a set of default read voltages are applied to distinguish each two adjacent final levels that switch between "0" and "1" or vice versa in the corresponding row of the data page. As shown in FIG. 12A, In one example, for LP, a first default read voltage may be applied between P1' and P2', a second default read voltage may be applied between P7' and P8', and a third default read voltage may be applied between P13' and P14'. In another example, for UP, a first default read voltage may be applied between P4' and P5', a second default read voltage may be applied between P9' and P10', a third default read voltage may be applied between P11' and P12', and a fourth default read voltage may be applied between P14' and P15'.

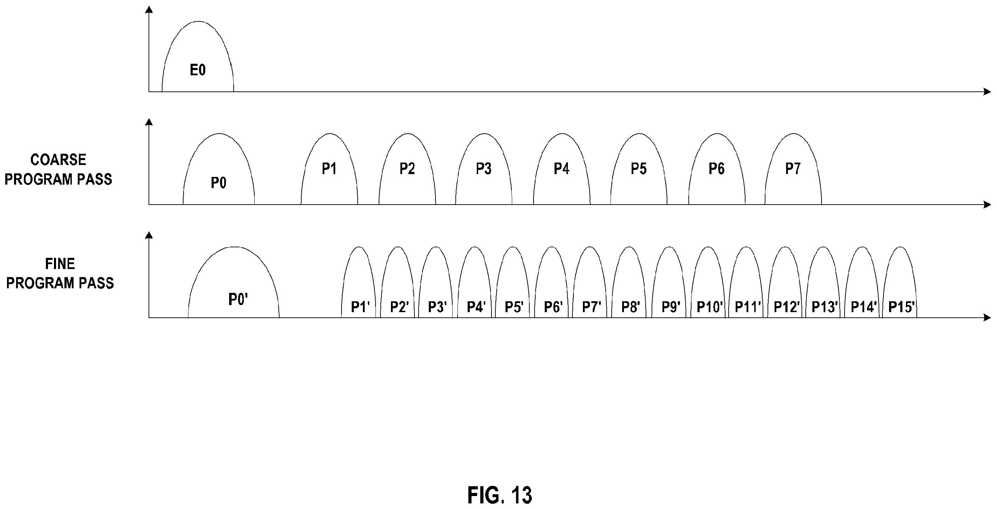

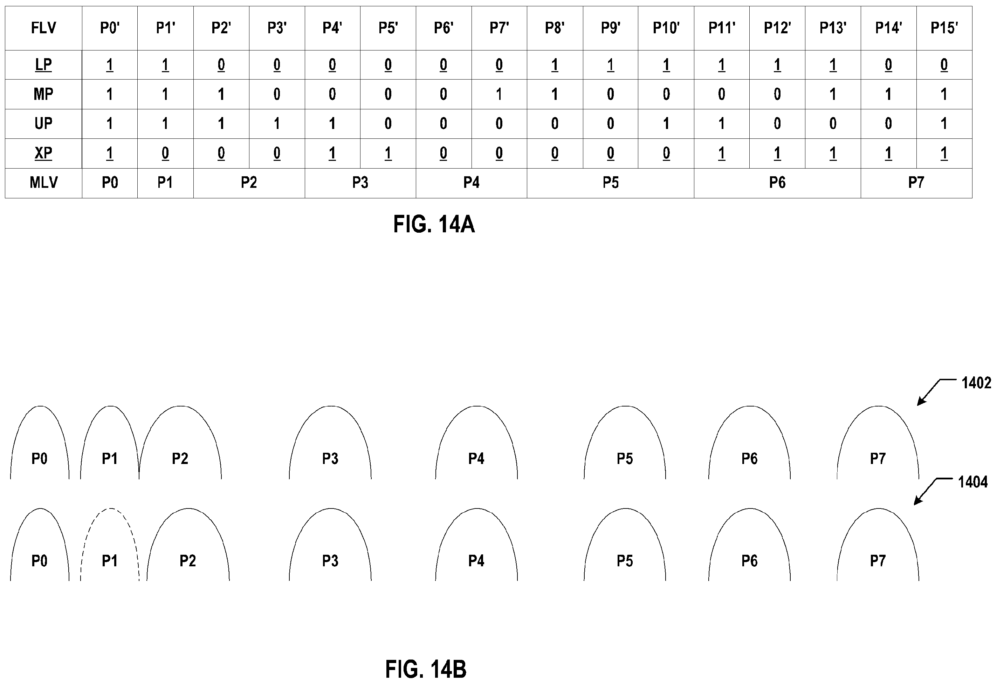

For example, FIG. 13 illustrates an example of threshold voltage distributions of memory cells in a third scheme of multi-pass program operations applied to QLCs, according to some aspects of the present disclosure. In this scheme, the number of intermediate levels *k,* e.g., 8, is smaller than the number of final levels 2*^{N}*, e.g., 16 for QLCs. As shown in FIG. 13, after the coarse program pass, each memory cell 106 is set to one of 8 intermediate levels P0-P7; after the fine program pass, each memory cell 106 is further set to one of 16 final levels PO'-P15'. FIG. 14A illustrates an example of a Gray code for the scheme of multi-pass program operation in FIG. 13, according to some aspects of the present disclosure. As shown in FIG. 14A, four data pages (*N =* 4 for QLCs) includes a lower page LP, a middle page MP, an upper page UP, and an extra page XP, which are used for programming memory cells 106 into a corresponding one of 8 intermediate levels MLVs in the coarse program pass and a corresponding one of 16 final levels FLVs in the fine program pass according to the Gray code. In some implementations, "0" in the Gray codes indicates an inhibited status, and "1" in the Gray codes indicates a programming status. As shown in FIG. 14A, each final level may correspond to one, two, or three intermediate levels. For example, intermediate levels P0 and P1 correspond to final level P0' and P1', respectively; intermediate level P2 corresponds to final levels P2' and P3'; intermediate level P3 corresponds to final levels P4' and P5'; intermediate level P4 corresponds to final levels P6' and P7'; intermediate level P7 corresponds to final levels P14' and P15'; intermediate level P5 corresponds to final levels P8', P9', and P10'; intermediate level P6 corresponds to final levels P11', P12', and P13'. It is understood that the mapping between intermediate levels and final levels may vary in different examples.

In read operations, to read a data page of the four data pages, a set of default read voltages are applied to distinguish each two adjacent final levels that switch between "0" and "1" or vice versa in the corresponding row of the data page. As shown in FIG. 14A, in one example, for LP, a first default read voltage may be applied between P1' and P2', a second default read voltage may be applied between P7' and P8', and a third default read voltage may be applied between P13' and P14'. In another example, for XP, a first default read voltage may be applied between P0' and P1', a second default read voltage may be applied between P3' and P4', a third default read voltage may be applied between P5' and P6', and a fourth default read voltage may be applied between P10' and P11'.

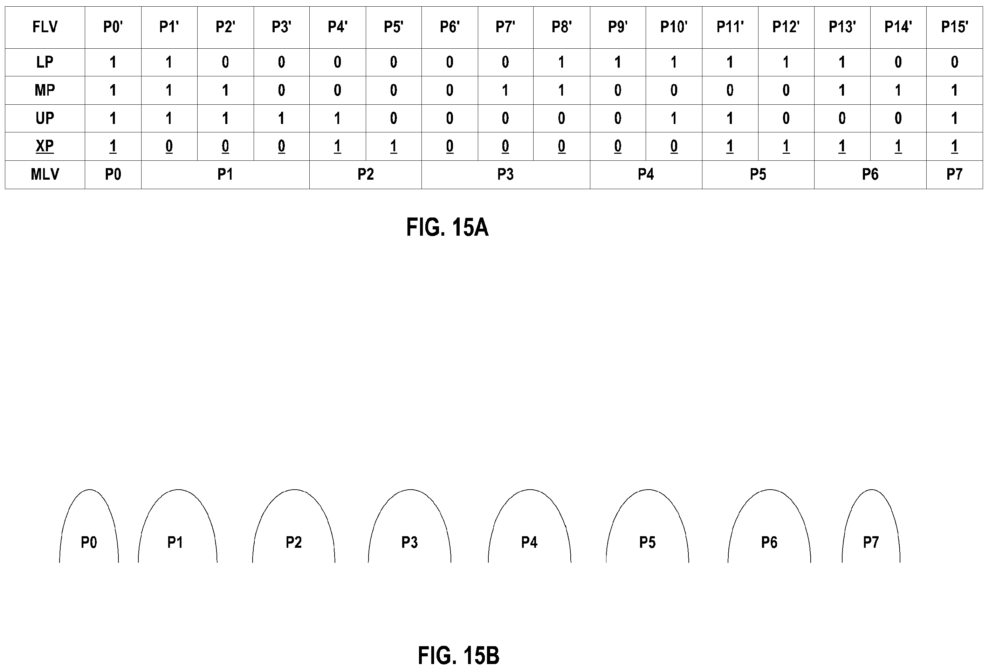

FIG. 15A illustrates another example of a Gray code for the scheme of multi-pass program operation in FIG. 13, according to some aspects of the present disclosure. As shown in FIG. 15A, four data pages (*N =* 4 for QLCs) includes a lower page LP, a middle page MP, an upper page UP, and an extra page XP, which are used for programming memory cells 106 into a corresponding one of 8 intermediate levels MLVs in the coarse program pass and a corresponding one of 16 final levels FLVs in the fine program pass according to the Gray code. In some implementations, "0" in the Gray codes indicates an inhibited status, and "1" in the Gray codes indicates a programming status. As shown in FIG. 15A, each final level may correspond to one, two, or three intermediate levels. For example, intermediate levels P0 and P7 correspond to final level P0' and P15', respectively; intermediate level P2 corresponds to final levels P4' and P5'; intermediate level P4 corresponds to final levels P9' and P10'; intermediate level P5 corresponds to final levels P11' and P12'; intermediate level P6 corresponds to final levels P13' and P14'; intermediate level P1 corresponds to final levels P1', P2', and P3'; intermediate level P3 corresponds to final levels P6', P7', and P8'. It is understood that the mapping between intermediate levels and final levels may vary in different examples.

In read operations, to read a data page of the four data pages, a set of default read voltages are applied to distinguish each two adjacent final levels that switch between "0" and "1" or vice versa in the corresponding row of the data page. As shown in FIG. 15A, for example, for XP, a first default read voltage may be applied between P0' and P1', a second default read voltage may be applied between P3' and P4', a third default read voltage may be applied between P5' and P6', and a fourth default read voltage may be applied between P10' and P11'.

Referring back to FIG. 16, if the answer to operation 1604 is "YES," method 1600 proceeds to operation 1606, as illustrated in FIG. 16, in which *M* data pages of the *N* data pages are read from the select row after the first pass, where *M* is an integer smaller than *N.* In some implementations, in order to read the *M* data pages after the first pass and prior to the second pass, at least two threshold voltage ranges corresponding to two adjacent intermediate levels of the *k* intermediate levels are non-overlapping. In some implementations, to read the *M* data pages, an adjusted read voltage is applied between the two threshold voltage ranges to the select word line. In some implementations, to read the *M* data pages, a default read voltage corresponding to the two adjacent intermediate levels based on a Gray code for programming the memory cells is applied to the select word line. The adjusted read voltage can be adjusted from the default read voltage by an offset.

For example, if the muti-pass program operation is interrupted by power loss of memory device 100 between first and second passes 702a and 702b, peripheral circuit 102 can be configured to read *M* data pages of the *N* data pages from the select row of memory cells 106 after first pass 702a, where *M* is an integer smaller than *N.* That is, instead of copying all *N* data pages to an SLC block of memory device 100 in response to the power loss, at least some of the data pages (*M* out of *N*) programmed after first pass 702a (i.e., part of the coarse data) can be read back from the select row of memory cells 106 after memory device 100 recovers from the power loss if the read window margins of the related intermediate levels are large enough. Thus, those *M* data pages may not need to be copied to the SLC block, and only the rest of the *(N-M)* data pages may need to be copied to the SLC block for power loss handling, thereby reducing the power loss handling duration and complexity.

As described above, to read a data page between the coarse and fine program passes, a set of read voltages need to be applied between certain adjacent intermediate levels that switch between "0" and "1" or vice versa in the corresponding row of the Gray code. Thus, the two threshold voltage ranges corresponding to each of those read-related adjacent intermediate levels need to be non-overlapping, e.g., having a sufficiently large read window margin, in order to read the corresponding data page, according to some implementations. Thus, in case any of those read-related adjacent intermediate levels do not have a sufficiently large read window margin for reading back coarse data after the coarse program pass, e.g., the corresponding two threshold voltage ranges are overlapping, the threshold voltage distributions of at least those intermediate levels need to be adjusted in the coarse program pass. In some implementations, to program the select row of memory cells 106 in first pass 702a, word line driver 308 is further configured to apply an adjusted verify voltage to select word line 118 for verifying a lower level of the two adjacent intermediate levels. The adjusted verify voltage can be smaller than a default verify voltage for verifying the lower level of the two adjacent intermediate levels. As a result, the read window margin between the two adjacent intermediate levels can be enlarged for ease of read-back.

For example, FIG. 10B illustrates an example of threshold voltage distributions of memory cells 106 after the coarse program pass of the first scheme of multi-pass program operation in FIG. 9, according to some aspects of the present disclosure. Threshold voltage distributions 1002 of memory cells 106 are formed by verifying memory cells 106 using a set of default coarse verify voltages, which may not have sufficient read window margins between adjacent intermediate levels. Threshold voltage distributions 1004 of memory cells 106 are formed by verifying memory cells 106 using a set of adjusted coarse verify voltages, which can enlarge read window margins between certain adjacent intermediate levels for reading certain coarse data pages.

According to the Gray code in FIG. 10A, for LP, a first coarse read voltage may be applied between P1 and P2, a second coarse read voltage may be applied between P7 and P8, and a third coarse read voltage may be applied between P13 and P14. Accordingly, a first adjusted coarse verify voltage smaller than the corresponding default coarse verify voltage may be applied for verifying P1 (i.e., the lower level of P1 and P2), a second adjusted coarse verify voltage smaller than the corresponding default coarse verify voltage may be applied for verifying P7 (i.e., the lower level of P7 and P8), and a third adjusted coarse verify voltage smaller than the corresponding default coarse verify voltage may be applied for verifying P13 (i.e., the lower level of P13 and P14). Similarly, as described above, for XP, a first coarse read voltage may be applied between P0 and P1, a second coarse read voltage may be applied between P3 and P4, a third coarse read voltage may be applied between P5 and P6, and a fourth coarse read voltage may be applied between P10 and P11. Accordingly, a first adjusted coarse verify voltage smaller than the corresponding default coarse verify voltage may be applied for verifying P3 (i.e., the lower level of P3 and P4), a second adjusted coarse verify voltage smaller than the corresponding default coarse verify voltage may be applied for verifying P5 (i.e., the lower level of P5 and P6), and a third adjusted coarse verify voltage smaller than the corresponding default coarse verify voltage may be applied for verifying P10 (i.e., the lower level of P10 and P11). It is understood that the read window margin between P0 and P1 is usually large enough even under the default verify voltages and thus, may not need to be enlarged. As a result, the read window margins between P1 and P2, P3 and P4, P5 and P6, P7 and P8, P10 and P11, and P13 and P14 can be enlarged by moving the threshold voltage ranges corresponding to P1, P3, P5, P7, P10, and P13 (indicated in dotted lines) to the left in FIG. 10B. As a result, LP and XP of the four data pages can be read after the coarse program pass in the multi-pass program operation. In some implementations, the threshold voltage ranges corresponding to two adjacent intermediate levels cannot be adjusted together, for example, P6 and P7, or P9 and P10. Thus, the read window margin between P6 and P7 or between P9 and P10 may not be sufficient for reading MP or UP after the coarse program pass.

For example, FIG. 12B illustrates an example of threshold voltage distributions of memory cells 106 after the coarse program pass of the second scheme of multi-pass program operation in FIG. 11, according to some aspects of the present disclosure. Threshold voltage distributions 1202 of memory cells 106 are formed by verifying memory cells 106 using a set of default coarse verify voltages, which may not have sufficient read window margins between some of the adjacent intermediate levels. Different from the first scheme in FIG. 10B, some of the adjacent intermediate levels in the second scheme in FIG. 12B may have sufficient read window margins even using default coarse verify voltages. Threshold voltage distributions 1204 of memory cells 106 are formed by verifying memory cells 106 using a set of adjusted coarse verify voltages, which can enlarge read window margins between certain adjacent intermediate levels for reading certain coarse data pages.

According to the Gray code in FIG. 12A, for LP, a first coarse read voltage may be applied between P1 and P2, a second coarse read voltage may be applied between P3 and P4, and a third coarse read voltage may be applied between P6 and P7. Accordingly, a first adjusted coarse verify voltage smaller than the corresponding default coarse verify voltage may be applied for verifying P1 (i.e., the lower level of P1 and P2), and a second adjusted coarse verify voltage smaller than the corresponding default coarse verify voltage may be applied for verifying P6 (i.e., the lower level of P6 and P7). It is understood that the read window margin between P3 and P4 may be large enough even under the default verify voltages and thus, may not need to be enlarged. Similarly, According to the Gray code in FIG. 12A, for UP, a first coarse read voltage may be applied between P2 and P3, a second coarse read voltage may be applied between P4 and P5, a third coarse read voltage may be applied between P5 and P6, and a fourth coarse read voltage may be applied between P7 and P8. Accordingly, an adjusted coarse verify voltage smaller than the corresponding default coarse verify voltage may be applied for verifying P7 (i.e., the lower level of P7 and P8). It is understood that the read window margins between P2 and P3, P4 and P5, and P5 and P6 may be large enough even under the default verify voltages and thus, may not need to be enlarged. As a result, the read window margins between P1 and P2, P6 and P7, and P7 and P8 can be enlarged by moving the threshold voltage ranges corresponding to P1, P6, and P7 (indicated in dotted lines) to the left in FIG. 12B. As a result, LP and UP of the four data pages can be read after the coarse program pass in the multi-pass program operation. In some implementations, MP and XP cannot be read after the coarse program pass since at least one of the intermediate levels corresponds to both "0" and "1" for those data pages according to the Gray code in FIG. 12A, for example, P2, P3, P4, and P6 for MP, and P2, P3, and P5 for XP.

For example, FIG. 14B illustrates an example of threshold voltage distributions of memory cells 106 after the coarse program pass of the third scheme of multi-pass program operation in FIG. 13, according to some aspects of the present disclosure. Threshold voltage distributions 1402 of memory cells 106 are formed by verifying memory cells 106 using a set of default coarse verify voltages, which may not have sufficient read window margins between some of the adjacent intermediate levels. Different from the first scheme in FIG. 10B, most of the adjacent intermediate levels in the second scheme in FIG. 14B may have sufficient read window margins even using default coarse verify voltages. Threshold voltage distributions 1404 of memory cells 106 are formed by verifying memory cells 106 using a set of adjusted coarse verify voltages, which can enlarge read window margins between certain adjacent intermediate levels for reading certain coarse data pages.

According to the Gray code in FIG. 14A, for LP, a first coarse read voltage may be applied between P1 and P2, a second coarse read voltage may be applied between P4 and P5, and a third coarse read voltage may be applied between P6 and P7. Accordingly, an adjusted coarse verify voltage smaller than the corresponding default coarse verify voltage may be applied for verifying P1 (i.e., the lower level of P1 and P2). It is understood that the read window margins between P4 and P5, and P6 and P7 may be large enough even under the default verify voltages and thus, may not need to be enlarged. Similarly, according to the Gray code in FIG. 14A, for XP, a first coarse read voltage may be applied between P2 and P3, a second coarse read voltage may be applied between P3 and P4, and a third coarse read voltage may be applied between P5 and P6. It is understood that the read window margins between P2 and P3, P3 and P4, and P5 and P6 may be large enough even under the default verify voltages and thus, may not need to be enlarged. As a result, the read window margin between P1 and P2 can be enlarged by moving the threshold voltage range corresponding to P1 (indicated in dotted lines) to the left in FIG. 14B. As a result, LP and XP of the four data pages can be read after the coarse program pass in the multi-pass program operation. In some implementations, MP and UP cannot be read after the coarse program pass since at least one of the intermediate levels corresponds to both "0" and "1" for those data pages according to the Gray code in FIG. 14A, for example, P2, P4, P5, and P6 for MP, and P3, P5, P6, and P7 for UP.

It is understood that in some examples, for example shown in FIG. 15B, all of the adjacent intermediate levels may have sufficient read window margins for read-back after the coarse program pass, even using default coarse verify voltages. Thus, the default coarse verify voltages (without any adjusted coarse verify voltage) may be used for verifying and forming all the intermediate levels. According to the Gray code in FIG. 15A, for XP, a first coarse read voltage may be applied between P0 and P1, a second coarse read voltage may be applied between P1 and P2, a third coarse read voltage may be applied between P2 and P3, and a fourth coarse read voltage may be applied between P4 and P5. As a result, XP of the four data pages can be read after the coarse program pass in the multi-pass program operation. In some implementations, LP, MP, and UP cannot be read after the coarse program pass since at least one of the intermediate levels corresponds to both "0" and "1" for those data pages according to the Gray code in FIG. 15A, for example, P1, P3, and P6 for LP, P1 and P3 for MP, and P2, P4, and P5 for UP.

To read the *M* data pages of the *N* data pages from the select row of memory cells 106 after first pass 702a, a set of coarse read voltages are applied by word line driver 308 to select word line 118, according to some implementations. Each coarse read voltage can be set between two threshold voltage ranges of corresponding read-related adjacent intermediate levels. However, read operations are usually performed by memory device 100 based on default read voltages corresponding to threshold voltage ranges of read-related adjacent final levels (i.e., fine read voltage), as opposed to intermediate levels. Thus, the coarse read voltages for performing read-back after the coarse program pass are adjusted from the default read voltages by offsets, according to some implementations.

The offsets between default read voltages (fine read voltages) and adjusted read voltages (coarse read voltages) are obtained by any suitable approaches. In one example, after power loss and then on, a tester may adjust the read voltage and scan the entire intermediate levels with a step voltage (e.g., 10 mv) from P0 to obtain the best read voltages (i.e., the coarse read voltages) between each intermediate level and the adjacent intermediate level. The best read voltages may be recorded, and the offsets may be equal to the differences between the default read voltages (i.e., the fine read voltages) and the recorded best read voltages. In some implementations, the offsets are stored in memory device 100, for example, certain memory cells 106, and retrieved by memory device 100 when reading some of the data pages after the coarse program pass. The retrieved offsets can be used, along with the corresponding fine read voltages based on the Grady code, to determine the coarse read voltages by control logic 312 of peripheral circuit 102.

For example, in the first scheme shown in FIGs. 10A and 10B, for LP, a first coarse read voltage between P1 and P2 may be adjusted from a first fine read voltage between P1' and P2' by a first offset, a second coarse read voltage between P7 and P8 may be adjusted from a second fine read voltage between P7' and P8' by a second offset, and a third coarse read voltage between P13 and P14 may be adjusted from a third fine read voltage between P13' and P14' by a third offset. TABLE 2 below illustrates an example of a correspondence table of each level and the corresponding read offset during readback in the first scheme.

**TABLE 2**

| **Level** | **Offset** |
|---|---|
| P0 | ΔV0 |
| P1 | ΔV1 |
| P2 | ΔV2 |
| ... | ... |
| P14 | ΔV14 |
| P15 | ΔV15 |

For example, in the second scheme shown in FIGs. 12A and 12B, for LP, a first coarse read voltage between P1 and P2 may be adjusted from a first fine read voltage between P1' and P2' by a first offset, a second coarse read voltage between P3 and P4 may be adjusted from a second fine read voltage between P7' and P8' by a second offset, and a third coarse read voltage between P6 and P7 may be adjusted from a third fine read voltage between P13' and P14' by a third offset.

For example, in the third scheme shown in FIGs. 14A and 14B, for LP, a first coarse read voltage between P1 and P2 may be adjusted from a first fine read voltage between P1' and P2' by a first offset, a second coarse read voltage between P4 and P5 may be adjusted from a second fine read voltage between P7' and P8' by a second offset, and a third coarse read voltage between P6 and P7 may be adjusted from a third fine read voltage between P13' and P14' by a third offset.

For example, in the fourth scheme shown in FIGs. 15A and 15B, for XP, a first coarse read voltage between P0 and P1 may be adjusted from a first fine read voltage between P0' and P1' by a first offset, a second coarse read voltage between P1 and P2 may be adjusted from a second fine read voltage between P3' and P4' by a second offset, a third coarse read voltage between P2 and P3 may be adjusted from a third fine read voltage between P5' and P6' by a third offset, and a fourth coarse read voltage between P4 and P5 may be adjusted from a fourth fine read voltage between P10' and P11' by a fourth offset. TABLE 3 below illustrates an example of a correspondence table of each level and the corresponding read offset during readback in the second, third, and fourth schemes.

**TABLE 3**

| **Level** | **Offset** |
|---|---|
| P0 | ΔV0 |
| P1 | ΔV1 |
| P2 | ΔV2 |
| ... | ... |
| P7 | ΔV7 |
| P8 | ΔV8 |

Method 1600 proceeds to operation 1608, as illustrated in FIG. 16, in which the remaining *(N-M)* data pages are copied to a designated block of the memory device after the first pass. For example, peripheral circuit 102 can be configured to copy the rest of *(N-M)* data pages that cannot be read back during the multiple-pass program operation to an SLC block of memory device 100 in response to the power loss. In response to the recovery of the power loss, peripheral circuit 102 can be configured to copy the rest of *(N-M)* data pages from the SLC block of memory device 100 for re-programming, along with the N data pages that are read back from memory cells 106.

The foregoing description of the specific implementations can be readily modified and/or adapted for various applications. Therefore, such adaptations and modifications are intended to be within the meaning and range of equivalents of the disclosed implementations, based on the teaching and guidance presented herein. The scope of the present disclosure should not be limited by any of the above-described exemplary implementations, but should be defined only in accordance with the following claims and their equivalents. Although specific configurations and arrangements are discussed, it should be understood that this is done for illustrative purposes only. As such, other configurations and arrangements can be used without departing from the scope of the present disclosure. Also, the subject matter as described in the present disclosure can also be used in a variety of other applications. Functional and structural features as described in the present disclosures can be combined, adjusted, modified, and rearranged with one another and in ways that are consistent with the scope of the present disclosure.

## Claims

1. A memory device (100), comprising:
an array of memory cells (106) in columns and rows, each memory cell (106) being set to one of 2*^{N}* final levels corresponding to a piece of N-bits data, where *N* is an integer greater than 2;
word lines (118) respectively coupled to rows of the memory cells (106); and
a peripheral circuit (102) coupled to the array of memory cells (106) through the word lines (118) and configured to:
program, in a first pass, a select row of the rows of the memory cells (106) based on *N* data pages, such that each memory cell (106) of the selected row is set to one of *k* intermediate levels, where *k* is an integer not greater than *2^{N};*
read *M* data pages of the *N* data pages from the select row after the first pass, where *M* is an integer smaller than N,
**characterised in that** the memory device is further comprising :
wherein the peripheral circuit (102) is configured to read the *M* data pages of the *N* data pages from the select row in response to a trigger event occurring, said trigger event comprising power loss of the memory device (100); and
copy remaining (*N-M*) data pages to a designated block of the array of memory cells (106) after the first pass.

2. The memory device of claim 1, wherein
the *k* intermediate levels correspond to *k* threshold voltage ranges, respectively, of the memory cells (106) of the select row; and
at least two threshold voltage ranges corresponding to two adjacent intermediate levels of the *k* intermediate levels are non-overlapping.

3. The memory device of claim 2, wherein to read the *M* data pages, the peripheral circuit (102) comprises a word line driver (308) coupled to the select row through a select word line (118) of the word lines (118), and configured to apply an adjusted read voltage between the two threshold voltage ranges to the select word line (118).

4. The memory device of claim 3, wherein to program the select row, the word linedriver (102) is further configured to apply an adjusted verify voltage to the select word line (118) for verifying a lower level of the two adjacent intermediate levels, the adjusted verify voltage being smaller than a default verify voltage for verifying the lower level of the two adjacent intermediate levels.

5. The memory device of claim 3 or 4, wherein the peripheral circuit is further configured to, in response to a trigger event not occurring:
skip reading the *M* data pages of the *N* data pages from the select row; and
program, in a second pass, the select row of the rows of the memory cells based on the *N* data pages after the first pass, such that each memory cell of the selected row is set to one of the 2*^{N}* final levels.

6. The memory device of claim 5, wherein the peripheral circuit is further configured to read the N data pages from the select row after the second pass.

7. The memory device of claim 6, wherein to read the N data pages, the word line driver is configured to apply a default read voltage corresponding to the two adjacent intermediate levels based on a Gray code for programming the memory cells (106) to the select word line (118), the adjusted read voltage being adjusted from the default read voltage by an offset.

8. The memory device of any one of claims 2-7, wherein the trigger event comprises power loss of the memory device (100).

9. A method for operating a memory device (100) comprising rows of memory cells (106), each memory cell (106) being set to one *of 2^{N}* final levels corresponding to a piece of N-bits data, where N is an integer greater than 2, the method comprising:
programming, in a first pass, a select row of the rows of the memory cells (106) based on *N* data pages, such that each memory cell (106) of the selected row is set to one of *k* intermediate levels, where *k* is an integer not greater than 2*^{N}*; and
reading *M* data pages of the *N* data pages from the select row after the first pass, where *M* is an integer smaller than *N*,
**characterised in that** the method is further comprising :
wherein reading the *M* data pages of the *N* data pages from the select row is in response to a trigger event occurring; and
copying remaining *(N-M)* data pages to a designated block of the memory device (100) after the first pass.

10. The method of claim 9, wherein
the *k* intermediate levels correspond to *k* threshold voltage ranges, respectively, of the memory cells (106) of the select row; and
at least two threshold voltage ranges corresponding to two adjacent intermediate levels of the *k* intermediate levels are non-overlapping.

11. The method of claim 10, wherein reading the *M* data pages comprises applying an adjusted read voltage between the two threshold voltage ranges to a select word line (118) coupled to the select row.

12. The method of claim 11, wherein programming the select row further comprises applying an adjusted verify voltage to the select word line (118) for verifying a lower level of the two adjacent intermediate levels, the adjusted verify voltage being smaller than a default verify voltage for verifying the lower level of the two adjacent intermediate levels.

13. The method of claim 11 or 12, further comprising, in response to a trigger event not occurring:
skipping reading the *M* data pages of the *N* data pages from the select row; and
programming, in a second pass, the select row of the rows of the memory cells based on the N data pages after the first pass, such that each memory cell of the selected row is set to one of the 2*^{N}* final levels.

14. The method of claim 10, further comprising reading the *N* data pages from the select row after the second pass.

15. The method of claim 14, wherein reading the *N* data pages comprises applying a default read voltage corresponding to the two adjacent intermediate levels based on a Gray code for programming the memory cells (106) to the select word line (118), the adjusted read voltage being adjusted from the default read voltage by an offset.

## Patentansprüche

1. Eine Speichervorrichtung (100), aufweisend:
eine Anordnung von Speicherzellen (106) in Spalten und Zeilen, wobei jede Speicherzelle (106) auf einen von 2*^{N}* Endpegeln eingestellt ist, die einem Stück von N-Bit-Daten entsprechen, wobei *N* eine ganze Zahl größer als 2 ist; Wortleitungen (118), die jeweils mit Zeilen der Speicherzellen (106) gekoppelt sind; und
eine Peripherieschaltung (102), die über die Wortleitungen (118) mit der Anordnung von Speicherzellen (106) gekoppelt und ausgebildet ist zum Programmieren einer ausgewählten Zeile der Zeilen der Speicherzellen (106) in einem ersten Durchgang auf der Grundlage von *N* Datenseiten derart, dass jede Speicherzelle (106) der ausgewählten Zeile auf einen von *k* Zwischenpegeln eingestellt wird, wobei *k* eine ganze Zahl nicht größer als 2*^{N}* ist;
Lesen von *M* Datenseiten der *N* Datenseiten aus der ausgewählten Zeile nach dem ersten Durchgang, wobei *M* eine ganze Zahl kleiner als *N* ist,
**dadurch gekennzeichnet, dass** die Speichervorrichtung ferner Folgendes aufweist:
wobei die Peripherieschaltung (102) ausgebildet ist zum Lesen der *M* Datenseiten der *N* Datenseiten aus der ausgewählten Zeile als Reaktion auf ein auslösendes Ereignis, wobei das auslösende Ereignis einen Stromausfall der Speichervorrichtung (100) umfasst; und
Kopieren der verbleibenden (*N*-*M*) Datenseiten in einen bestimmten Block des Arrays von Speicherzellen (106) nach dem ersten Durchlauf.

2. Speichervorrichtung nach Anspruch 1, wobei
die *k* Zwischenpegel jeweils *k* Schwellenspannungsbereichen der Speicherzellen (106) der ausgewählten Zeile entsprechen; und mindestens zwei Schwellenspannungsbereiche, die zwei benachbarten Zwischenpegeln der *k* Zwischenpegel entsprechen, sich nicht überlappen.

3. Speichervorrichtung nach Anspruch 2, wobei die Peripherieschaltung (102) zum Lesen der *M* Datenseiten einen Wortleitungstreiber (308) aufweist, der über eine ausgewählte Wortleitung (118) der Wortleitungen (118) mit der ausgewählten Zeile gekoppelt ist und so konfiguriert ist, dass er eine angepasste Lesespannung zwischen den beiden Schwellenspannungsbereichen an die ausgewählte Wortleitung (118) anlegt.

4. Speichervorrichtung nach Anspruch 3, wobei zum Programmieren der ausgewählten Zeile der Wortleitungstreiber (102) ferner so konfiguriert ist, dass er eine angepasste Verifizierungsspannung an die ausgewählte Wortleitung (118) anlegt, um einen niedrigeren Pegel der beiden benachbarten Zwischenpegel zu verifizieren, wobei die angepasste Verifizierungsspannung kleiner ist als eine Standard-Verifizierungsspannung zum Verifizieren des niedrigeren Pegels der beiden benachbarten Zwischenpegel.

5. Speichervorrichtung nach Anspruch 3 oder 4, wobei die Peripherieschaltung ferner als Reaktion darauf, dass das auslösende Ereignis nicht eintritt ausgebildet ist zum:
Überspringen des Lesens der *M* Datenseiten der *N* Datenseiten aus der ausgewählten Zeile; und
Programmieren der ausgewählten Zeile der Zeilen der Speicherzellen in einem zweiten Durchgang auf der Grundlage der *N* Datenseiten nach dem ersten Durchgang derart, dass jede Speicherzelle der ausgewählten Zeile auf einen der 2*^{N}* Endpegel gesetzt wird.

6. Speichervorrichtung nach Anspruch 5, wobei die Peripherieschaltung ferner ausgebildet ist zum Lesen der *N* Datenseiten aus der ausgewählten Zeile nach dem zweiten Durchgang.

7. Speichervorrichtung nach Anspruch 6, wobei zum Lesen der N Datenseiten der Wortleitungstreiber so konfiguriert ist, dass er eine Standard-Lesespannung, die den beiden benachbarten Zwischenpegeln entspricht, basierend auf einem Gray-Code zum Programmieren der Speicherzellen (106) an die ausgewählte Wortleitung (118) anlegt, wobei die angepasste Lesespannung durch einen Offset von der Standard-Lesespannung angepasst wird.

8. Speichervorrichtung nach einem der Ansprüche 2 bis 7, wobei das auslösende Ereignis einen Stromausfall des Speicherbauelements (100) umfasst.

9. Verfahren zum Betreiben einer Speichervorrichtung (100), die Reihen von Speicherzellen (106) umfasst, wobei jede Speicherzelle (106) auf einen von 2*^{N}* Endpegeln eingestellt ist, die einem Stück von *N*-Bit-Daten entsprechen, wobei *N* eine ganze Zahl größer als 2 ist, wobei das Verfahren folgende Schritte aufweist:
Programmieren einer ausgewählten Zeile der Zeilen der Speicherzellen (106) in einem ersten Durchgang auf der Grundlage von *N* Datenseiten, so dass jede Speicherzelle (106) der ausgewählten Zeile auf einen von *k* Zwischenpegeln eingestellt wird, wobei *k* eine ganze Zahl nicht größer als 2*^{N}* ist; und
**dadurch gekennzeichnet, dass** das Verfahren ferner folgende Schritte aufweist:
Lesen von *M* Datenseiten der *N* Datenseiten aus der ausgewählten Zeile nach dem ersten Durchgang, wobei *M* eine ganze Zahl kleiner als *N* ist,
wobei das Lesen der *M* Datenseiten der N Datenseiten aus der ausgewählten Zeile als Reaktion auf ein auftretendes auslösendes Ereignis erfolgt; und
Kopieren der verbleibenden (*N*-*M*) Datenseiten in einen bestimmten Block der Speichervorrichtung (100) nach dem ersten Durchgang.

10. Verfahren nach Anspruch 9, wobei
die *k* Zwischenpegel jeweils *k* Schwellenspannungsbereichen der Speicherzellen (106) der ausgewählten Zeile entsprechen; und
mindestens zwei Schwellenspannungsbereiche, die zwei benachbarten Zwischenpegeln der *k* Zwischenpegel entsprechen, sich nicht überlappen.

11. Verfahren nach Anspruch 10, wobei das Lesen der *M* Datenseiten das Anlegen einer angepassten Lesespannung zwischen den beiden Schwellenspannungsbereichen an eine mit der ausgewählten Zeile gekoppelte ausgewählte Wortleitung (118) umfasst.

12. Verfahren nach Anspruch 11, wobei das Programmieren der ausgewählten Zeile ferner das Anlegen einer angepassten Verifizierungsspannung an die ausgewählte Wortleitung (118) zum Verifizieren eines niedrigeren Pegels der beiden benachbarten Zwischenpegel umfasst, wobei die angepasste Verifizierungsspannung kleiner ist als eine Standard-Verifizierungsspannung zum Verifizieren des niedrigeren Pegels der beiden benachbarten Zwischenpegel.

13. Verfahren nach Anspruch 11 oder 12, das ferner folgenden Schritt als Reaktion darauf, dass das auslösende Ereignis nicht eintritt, aufweist:
Überspringen des Lesens der *M* Datenseiten der *N* Datenseiten aus der ausgewählten Zeile; und
Programmieren der ausgewählten Zeile der Zeilen der Speicherzellen in einem zweiten Durchgang auf der Grundlage der *N* Datenseiten nach dem ersten Durchgang, so dass jede Speicherzelle der ausgewählten Zeile auf einen der 2*^{N}* Endpegel gesetzt wird.

14. Verfahren nach Anspruch 10, das ferner folgenden Schritt aufweist: Lesen der N Datenseiten aus der ausgewählten Zeile nach dem zweiten Durchgang.

15. Verfahren nach Anspruch 14, wobei das Lesen der *N* Datenseiten folgenden Schritt aufweist: Anlegen einer Standard-Lesespannung, die den beiden benachbarten Zwischenpegeln auf der Grundlage eines Gray-Codes zum Programmieren der Speicherzellen (106) an die ausgewählte Wortleitung (118) entspricht, wobei die angepasste Lesespannung durch einen Offset von der Standard-Lesespannung angepasst wird.

## Revendications

1. Dispositif de mémoire (100), comprenant :
une matrice de cellules de mémoire (106) en colonnes et en rangées, chaque cellule de mémoire (106) étant définie sur l'un de 2*^{N}* niveaux finaux correspondant à un élément de données de *N* bits, où *N* est un entier supérieur à 2 ;
des lignes de mots (118) couplées respectivement à des rangées des cellules de mémoire (106) ; et
un circuit périphérique (102) couplé à la matrice de cellules de mémoire (106) par l'intermédiaire des lignes de mots (118) et configuré pour :
programmer, dans une première passe, une rangée sélectionnée des rangées des cellules de mémoire (106) sur la base de N pages de données, de telle sorte que chaque cellule de mémoire (106) de la rangée sélectionnée est définie sur l'un de *k* niveaux intermédiaires, où *k* est un entier qui n'est pas supérieur à 2*^{N}* ;
lire *M* pages de données des *N* pages de données à partir de la rangée sélectionnée après la première passe, où *M* est un entier inférieur à *N,*
**caractérisé en ce que** le dispositif de mémoire comprend en outre :
dans lequel le circuit périphérique (102) est configuré pour lire les *M* pages de données des N pages de données à partir de la rangée sélectionnée en réponse à une occurrence d'un événement déclencheur, ledit événement déclencheur comprenant une perte de puissance du dispositif de mémoire (100) ; et
copier *(N-M)* pages de données restantes sur un bloc désigné de la matrice de cellules de mémoire (106) après la première passe.

2. Dispositif de mémoire selon la revendication 1, dans lequel
les *k* niveaux intermédiaires correspondent à *k* plages de tension seuil, respectivement, des cellules de mémoire (106) de la rangée sélectionnée ;
et
au moins deux plages de tension seuil correspondant à deux niveaux intermédiaires adjacents des *k* niveaux intermédiaires ne sont pas en chevauchement.

3. Dispositif de mémoire selon la revendication 2, dans lequel, pour lire les *M* pages de données, le circuit périphérique (102) comprend un pilote de ligne de mots (308) couplé à la rangée sélectionnée par l'intermédiaire d'une ligne de mots sélectionnée (118) des lignes de mots (118), et est configuré pour appliquer une tension de lecture ajustée entre les deux plages de tension seuil sur la ligne de mots sélectionnée (118).

4. Dispositif de mémoire selon la revendication 3, dans lequel, pour programmer la rangée sélectionnée, le pilote de ligne de mots (102) est en outre configuré pour appliquer une tension de vérification ajustée sur la ligne de mots sélectionnée (118) pour vérifier un niveau bas des deux niveaux intermédiaires adjacents, la tension de vérification ajustée étant inférieure à une tension de vérification par défaut pour vérifier le niveau bas des deux niveaux intermédiaires adjacents.

5. Dispositif de mémoire selon la revendication 3 ou 4, dans lequel le circuit périphérique est en outre configuré pour, en réponse à une non-occurrence d'un événement déclencheur :
sauter la lecture des *M* pages de données des *N* pages de données à partir de la rangée sélectionnée ; et
programmer, dans une seconde passe, la rangée sélectionnée des rangées de cellules de mémoire sur la base des *N* pages de données après la première passe, de telle sorte que chaque cellule de mémoire de la rangée sélectionnée est définie sur l'un des 2*^{N}* niveaux finaux.

6. Dispositif de mémoire selon la revendication 5, dans lequel le circuit périphérique est en outre configuré pour lire les *N* pages de données à partir de la rangée sélectionnée après la seconde passe.

7. Dispositif de mémoire selon la revendication 6, dans lequel, pour lire les *N* pages de données, le pilote de ligne de mots est configuré pour appliquer une tension de lecture par défaut sur les deux niveaux intermédiaires adjacents sur la base d'un code de Gray pour programmer les cellules de mémoire (106) sur la ligne de mots sélectionnée (118), la tension de lecture ajustée étant ajustée à partir de la tension de lecture par défaut via un décalage.

8. Dispositif de mémoire selon l'une quelconque des revendications 2 à 7, dans lequel l'événement déclencheur comprend une perte de puissance du dispositif de mémoire (100).

9. Procédé de fonctionnement d'un dispositif de mémoire (100) comprenant des rangées de cellules de mémoire (106), chaque cellule de mémoire (106) étant définie sur l'un de 2*^{N}* niveaux finaux correspondant à un élément de données de *N* bits, où *N* est un entier supérieur à 2, le procédé comprenant les étapes consistant à :
programmer, dans une première passe, une rangée sélectionnée des rangées des cellules de mémoire (106) sur la base de N pages de données, de telle sorte que chaque cellule de mémoire (106) de la rangée sélectionnée est définie sur l'un de *k* niveaux intermédiaires, où *k* est un entier qui n'est pas supérieur à 2*^{N}*; et
**caractérisé en ce que** le procédé comprend en outre les étapes consistant à :
lire *M* pages de données des *N* pages de données à partir de la rangée sélectionnée après la première passe, où *M* est un entier inférieur à *N,*
dans lequel l'étape consistant à lire les *M* pages de données des *N* pages de données à partir de la rangée sélectionnée est en réponse à une occurrence d'événement déclencheur ; et
copier (*N*-*M*) pages de données restantes sur un bloc désigné du dispositif de mémoire (100) après la première passe.

10. Procédé selon la revendication 9, dans lequel
les *k* niveaux intermédiaires correspondent à *k* plages de tension seuil, respectivement, des cellules de mémoire (106) de la rangée sélectionnée ; et
au moins deux plages de tension seuil correspondant à deux niveaux intermédiaires adjacents des *k* niveaux intermédiaires ne sont pas en chevauchement.

11. Procédé selon la revendication 10, dans lequel l'étape consistant à lire les *M* pages de données comprend d'appliquer une tension de lecture ajustée entre les deux plages de tension seuil sur une ligne de mots sélectionnée (118) couplée à la rangée sélectionnée.

12. Procédé selon la revendication 11, dans lequel l'étape consistant à programmer la rangée sélectionnée comprend en outre d'appliquer une tension de vérification sur la ligne de mots sélectionnée (118) pour vérifier un niveau bas des deux niveaux intermédiaires adjacents, la tension de vérification ajustée étant inférieure à une tension de vérification par défaut pour vérifier le niveau bas des deux niveaux intermédiaires adjacents.

13. Procédé selon la revendication 11 ou 12, comprenant en outre, en réponse à une non-occurrence d'un événement déclencheur, les étapes consistant à :
sauter la lecture des *M* pages de données des *N* pages de données à partir de la rangée sélectionnée ; et
programmer, dans une seconde passe, la rangée sélectionnée des rangées des cellules de mémoire sur la base des *N* pages de données après la première passe, de telle sorte que chaque cellule de mémoire de la rangée sélectionnée est définie sur l'un des 2*^{N}* niveaux finaux.

14. Procédé selon la revendication 10, comprenant en outre l'étape consistant à lire les *N* pages de données à partir de la rangée sélectionnée après la seconde passe.

15. Procédé selon la revendication 14, dans lequel l'étape consistant à lire les *N* pages de données comprend d'appliquer une tension de lecture par défaut correspondant aux deux niveaux intermédiaires adjacents sur la base d'un code de Gray pour programmer les cellules de mémoire (106) sur la ligne de mots sélectionnée (118), la tension de lecture ajustée étant ajustée à partir de la tension de lecture par défaut via un décalage.
